# EUROPÄISCHE PATENTSCHRIFT

(11) **EP 4 016 094 B1**
(45) Veröffentlichungstag und Bekanntmachung des Hinweises auf die Patenterteilung: **07.02.2024**
(21) Anmeldenummer: 21213754.1
(22) Anmeldetag: 10.12.2021
(51) Int. Cl.: G01R 29/14

(54) **VERFAHREN UND VORRICHTUNG ZUR DETEKTION VON ELEKTRISCHEN SPANNUNGEN UND/ODER ELEKTRISCHEN STRÖMEN**
METHOD AND DEVICE FOR DETECTING ELECTRICAL VOLTAGES AND / OR ELECTRICAL CURRENTS
PROCÉDÉ ET DISPOSITIF DE DÉTECTION DES TENSIONS ÉLECTRIQUES ET/OU DES COURANTS ÉLECTRIQUES

(30) Priorität: 18.12.2020 DE 102020134199
(43) Veröffentlichungstag der Anmeldung: 22.06.2022
(73) Patentinhaber: Peek GmbH, 82211 Herrsching a. Ammersee (DE)
(72) Erfinder: STAMMEL, Christian, 82211 Herrsching/Breitbrunn (DE); FRÜHSCHÜTZ, Hannes, 82418 Murnau am Staffelsee (DE); JANTA, Marius, 85354 Freising (DE); KANDLBINDER, Jürgen, 93059 Regensburg (DE); LEUCHTENBERGER, Roland, 93059 Regensburg (DE)
(74) Vertreter: Samson & Partner Patentanwälte mbB

(56) Entgegenhaltungen:
- US-A1- 2007 279 067
- US-A1- 2011 184 679
- US-A1- 2018 225 946

## Beschreibung

Die vorliegende Erfindung betrifft ein Verfahren sowie eine Vorrichtung zur Detektion von elektrischem Strom und/oder elektrischer Spannung durch Erkennen der der Lage und/oder der technischen und physikalischen Eigenschaften von stromführenden bzw. spannungstragenden Objekten und Komponenten in einer Umgebung z.B. mittels auf künstlicher Intelligenz basierenden Verfahren.

### Hintergrund

Eine schnelle, genaue und zuverlässige Kenntnis über die Lage und den Verlauf von stromführenden Leitungen und Leitungssystemen sowie spannungstagenden Komponenten, insbesondere hochspannungstragenden Komponenten in einer Umgebung, wie z.B. einer Industrieanlage, einer Trafostation, einer Freileitung oder auch einem Gebäude, in dem Starkstromkabel verlegt sind, sind für eine ganze Reihe von Arbeiten, wie z.B. Bau-, Montage-, und Wartungsarbeiten von entscheidender Bedeutung. Personal, welches mit der Durchführung von Arbeiten in solchen Umgebungen beauftragt ist und sich beispielweise noch in einer anfänglichen Unkenntnis über die genaue Lage von stromführenden und spannungstragenden Komponenten befindet, kann oft Schwierigkeiten haben, sich rasch ein genaues Bild über die gegenwärtige Situation zu verschaffen und somit die richtigen Entscheidungen zu fällen und die geeigneten Maßnahmen zu ergreifen.

Hinzu kommt der Umstand, dass der Umgang mit elektrischem Strom oder elektrischer Spannung, insbesondere Hochspannung, mit erheblichen gesundheitsgefährdenden, zum Teil tödlichen Gefahren verbunden sein kann. Personal, welches in einer Umgebung mit elektrischen Komponenten arbeitet und sich darin bewegt, ist einem erhöhten Gefährdungspotential ausgesetzt. Dieses Gefährdungspotential kann durch menschliches Versagen noch gesteigert werden. In Falle von Hochspannung und Starkstrom genügt bereits eine hinreichende Annäherung an die betreffende Komponente, um beispielsweise einen Lichtbogenunfall zu erleiden.

So kann es für eine Person von entscheidender Bedeutung sein, bereits in Vorneherein zu wissen, ob eine Bewegung in eine bestimmte räumliche Richtung beispielsweise auf eine stromführende Komponente zuführt und daher mit Gefahren verbunden ist. Eine umgehende und verlässliche Kenntnis über das System von elektrischen Komponenten und deren räumliche Struktur und deren räumlichen Verlauf ist daher von großer Bedeutung.

Eine genaue Kenntnis über stromführende und (hoch)spannungstragende Strukturen kann aber auch bei Erzeugnissen und Produkten, die jüngeren und jüngsten technologischen Entwicklungen zuzurechnen sind wie Elektroautos, autonome Roboter, Solaranlagen etc. notwendig sein. Auch hier kann durch Arbeiten an diesen Erzeugnissen durch elektrisch geladene und stromführende Komponenten eine Gefahr für das entsprechende Personal bestehen, welche durch menschliches Versagen oder durch eine Fehlfunktion einer dieser Komponenten noch erhöht werden kann. In solchen Fällen ist es von enormer Bedeutung, zu Erkennen ob eine Gefahr besteht und diese Gefahr anschließend klassifizieren zu können.

Aus dem Stand der Technik sind elektrische Ortungsgeräte wie Leitungssucher bekannt, welche in Wänden verborgene Stromleitungen detektieren. Dies hilft unter anderem zu verhindern, dass beispielsweise beim Bohren von Löchern in Wänden unerwartet eine Leitung getroffen wird und es infolgedessen zu einem Stromunfall kommen kann.

Ein Ortungsgerät (auch als Leitungssucher, Leitungsfinder, Balkenfinder oder Multidetektor bekannt) dient, insbesondere im Rahmen der Haustechnik, der Lokalisierung von nicht sichtbaren Objekten innerhalb von Wänden, Decken und Böden wie elektrischen Leitungen, aber auch Wasser- und Gasleitungen, Moniereisen, oder Ständerkonstruktionen. Die Detektion fußt bei Ortungsgeräten zumeist auf der Detektion von durch elektrische Ströme induzierten elektrischen, magnetischen oder elektromagnetischen Feldern.

Zu weiteren Strommessgeräten bzw. Spannungsmessgeräten, welche elektrische Ströme aufgrund der von diesen erzeugten elektromagnetischen Feldern messen, sind u. a. Stromsensoren sowie Zangenstrommesser, aber auch Feldmühlen zu zählen.

Die elektrischen, magnetischen oder elektromagnetischen Felder der vorgenannten Messgeräte werden im Stand der Technik üblicherweise nach einem einzigen Verfahren bestimmt. So kann ein elektrisches Feld beispielsweise mit einem kapazitiven Verfahren bestimmt werden.

WO 2018/111474 A1 beschreibt eine Warnvorrichtung zur Erkennung elektrisch geladener Leiter. Ein oder mehrere felddetektierende Sensoren sind so konfiguriert, dass sie durch die Erfassung entsprechender elektrischer und/oder magnetischer Felder einen geladenen Leiter erkennen, der sich der Nähe des Ortes der Warnvorrichtung befindet. Darüber hinaus wird eine ungefähre Richtung erkannt, in der sich der Leiter in Bezug auf den Ort der Warnvorrichtung befindet.

EP 3 144 686 A1 beschreibt ein Sicherheitselement gegen Stromschlaggefahr. Das Sicherheitselement umfasst Erfassungsmittel zum Erfassen von Messsignalen eines elektrischen Feldes und Alarmmittel zum Generieren eines Warnsignals. Es sind ferner ein Bewegungsmesselement zum Messen einer Bewegung der Schutzvorrichtung sowie eine Steuereinheit vorgesehen, welche die erfassten elektrischen Feldmesssignale verarbeitet und deren Variation berechnet, wenn die persönliche Schutzvorrichtung durch das elektrische Feld bewegt wird.

EP 3 124 983 B1 beschreibt ein persönliches Sicherheitssystem, das an einem Schutzhelm befestigt wird und einen Spannungsdetektor umfasst, um ein elektrisches Umgebungsfeld zu detektieren, sowie ein Signalisierungssystem, um ein Signalisierungssignal an eine Person zu senden, wenn der Spannungsdetektor ein elektrisches Umgebungsfeld erfasst, das größer als eine Erfassungsschwelle ist.

Der Nachteil solcher nur auf einer einzigen Messmethode basierenden Strom- und Spannungsdetektionsverfahren ist, dass es oft nicht möglich ist, alle spannungstragenden und stromführenden Komponenten in einer Anlage oder einer Umgebung wie beispielsweise einer Transformatorstation, einem Umspannwerk, aber auch in einem Zimmer schnell, zuverlässig und vollständig zu detektieren, zu lokalisieren und voneinander zu unterscheiden.

US 2018/0225946 A1 beschreibt ein Verfahren und eine Vorrichtung zum Erkennen und Identifizieren gefährlicher Objekte in elektrischen Feldern, wie z. B. im öffentlichen Raum verlegte elektrische Leitungen und Installationen. In einer Ausführungsform umfasst die Vorrichtung ein Sensorsystem mit zwei oder mehr Sensorsonden, die an einem mobilen Fahrzeug angebracht und voneinander beabstandet sind, wobei jede Sensorsonde der zwei oder mehr Sensorsonden ein einem elektrischen Feld entsprechendes Signal erzeugt; einen Prozessor, der mit den zwei oder mehr Sensorsonden gekoppelt ist, um die Signale von den zwei oder mehr Sensorsonden zu verarbeiten, um mindestens ein verarbeitetes Signal auf der Grundlage eines Abstands zwischen mindestens zwei Sensorsonden der zwei oder mehr Sensorsonden zu erzeugen; und einen Indikator, der mit dem Prozessor gekoppelt ist, um auf der Grundlage des mindestens einen verarbeiteten Signals einen Hinweis auf eine Gefahrenstelle in dem elektrischen Feld zu liefern.

US 2007/279067 A1 beschreibt einen Streuspannungsdetektor mit einem tragbaren Gehäuse, das ein Paar elektrostatischer Ladungssensoren trägt, die entlang einer Achse voneinander beabstandet sind, und ein Paar von Feldstärkeindikatoren, wobei jeder Indikator mit einem zugehörigen Ladungssensor verbunden und so konstruiert ist, dass er eine relative elektrische Feldstärke an seinem zugehörigen Sensor anzeigt. Der Spannungsdetektor ist so konstruiert, dass er einem Bediener, der das Gehäuse entlang der Achse über eine Oberfläche mit einem lokalisierten Bereich mit erhöhter Spannung bewegt, eine gleichzeitige Rückmeldung der elektrischen Feldstärke von beiden Indikatoren liefert, um die Lokalisierung des lokalisierten Bereichs mit erhöhter Spannung zu unterstützen. Die Rückmeldung kann beispielsweise über einen Touch-Screen erfolgen. Der Detektor ist nützlich, um Hochspannungsbereiche zu lokalisieren, selbst wenn durch diese Bereiche nur wenig oder kein Strom fließt, der ein Magnetfeld erzeugt.

US 2011/184679 A1 beschreibt ein Verfahren und eine Vorrichtung zur Unterscheidung zwischen elektrischen Feldquellen. In einer Ausführungsform umfasst die Vorrichtung ein mobiles Detektionssystem, das beispielsweise auf einem Fahrzeug montiert ist, das eine Sensorsonde zur Fernmessung eines elektrischen Feldes, das von einer elektrischen Feldquelle in einem patrouillierten Gebiet erzeugt wird, und einen Prozessor umfasst, der mit der Sensorsonde gekoppelt ist, um die von der Sensorsonde empfangenen Daten zu verarbeiten, um zu bestimmen, ob die elektrische Feldquelle potenziell gefährlich ist.

Die bezeichneten Probleme im vorgenannten Stand-der-Technik werden durch die anspruchsgemäßen Verfahren und Vorrichtungen gelöst.

### Kurzfassung der Erfindung

Gemäß einem ersten Aspekt umfasst die Erfindung ein Verfahren zur automatisierten Erkennung ein oder mehrerer elektrischer Spannungen und/oder elektrischer Ströme. Das Verfahren umfasst hierbei das Bereitstellen von berechneten Daten zu den ein oder mehreren elektrischen Spannungen und/oder den elektrischen Strömen, wobei die berechneten Daten die räumlichen Positionen mindestens eines Trägers der ein oder mehreren elektrischen Spannungen und/oder der elektrischen Ströme umfassen und wobei die berechneten Daten aus einem Satz von Messdaten zu einer Mehrzahl erster Detektionen der ein oder mehreren elektrischen Spannungen und/oder der elektrischen Ströme berechnet worden sind. Das Verfahren umfasst weiter das Durchführen einer zweiten Detektion der ein oder mehreren elektrischen Spannungen und/oder der elektrischen Ströme, wobei bei der zweiten Detektion Messdaten zu der zweiten Detektion erzeugt werden, und aus den Messdaten der zweiten Detektion und den berechneten Daten aktualisierte berechnete Daten zu den ein oder mehreren elektrischen Spannungen und/oder den elektrischen Strömen erzeugt werden. Das Umfahren umfasst zusätzlich das Ausgeben der aktualisierten berechneten Daten, um die räumlichen Positionen und/oder die Eigenschaften des mindestens eines Trägers der ein oder mehreren elektrischen Spannungen und/oder der elektrischen Ströme anzuzeigen. Das Verfahren umfasst weiter das vorgenannte Bereitstellen, Durchführen und Ausgeben mittels einer durch ein Armband oder ein Stirnband am menschlichen Körper tragbaren Vorrichtung.

Gemäß einem zweiten Aspekt umfasst die Erfindung eine Vorrichtung zur automatisierten Erkennung ein oder mehrerer elektrischer Spannungen und/oder elektrischer Ströme, umfassend Mittel zum Bereitstellen von berechneten Daten zu den ein oder mehreren elektrischen Spannungen und/oder den elektrischen Strömen, wobei die berechneten Daten die räumlichen Positionen mindestens eines Trägers der ein oder mehreren elektrischen Spannungen und/oder der elektrischen Ströme umfassen und wobei die berechneten Daten aus einem Satz von Messdaten zu einer Mehrzahl erster Detektionen der ein oder mehreren elektrischen Spannungen und/oder der elektrischen Ströme berechnet worden sind. Die Vorrichtung umfasst ferner Mittel zum Durchführen einer zweiten Detektion der ein oder mehreren elektrischen Spannungen und/oder der elektrischen Ströme wobei bei der zweiten Detektion Messdaten zu der zweiten Detektion erzeugt werden, und aus den Messdaten der zweiten Detektion und den berechneten Daten aktualisierte berechnete Daten zu den ein oder mehreren elektrischen Spannungen und/oder den elektrischen Strömen erzeugt werden. Die Vorrichtung umfasst zusätzlich Mittel zum Ausgeben der aktualisierten berechneten Daten, um die räumlichen Positionen und/oder die Eigenschaften des mindestens eines Trägers der ein oder mehreren elektrischen Spannungen und/oder der elektrischen Ströme anzuzeigen. Die Vorrichtung ist mittels eines Armbandes oder eines Stirnbandes am menschlichen Körper tragbar.

Gemäß einem dritten Aspekt umfasst die Erfindung eine Anzeigevorrichtung zum Ausgeben mindestens eines Signals, umfassend die Vorrichtung nach einem der vorangehenden Ansprüche, wobei das mindestens eine Signal das mindestens eine Ausgabesignal nach einem der vorhergehenden Ansprüche umfasst.

Weitere Aspekte der Erfindung sind in den abhängigen Ansprüchen definiert.

### Bevorzugte Ausführungsbeispiele

Im Folgenden werden bevorzugte Ausführungsbeispiele der Erfindung anhand der Zeichnungen in ihrem Aufbau und in ihrer Wirkungsweise näher erläutert.
Figur 1 zeigt schematisch ein elektrisches Umspannwerk in einem Versorgungsspannungsnetz.
Figur 2 zeigt ein Ausschnitt aus einer Überlandleitung, bei der eine Übertragungsleitung abgeschaltet ist.
Figur 3 zeigt schematisch eine Transformatorenstation mit einer angeschlossenen und einer abgeschalteten Zelle.
Figur 4 zeigt die in Figur 3 dargestellte Konfiguration, wobei an der abgeschalteten Zelle aufgrund eines technischen Fehlers dennoch Strom anliegt.
Figur 5 zeigt schematisch die Erzeugung aktualisierter berechneter Daten zu stromführenden und spannungstragenden Komponenten gemäß einer Ausführungsform.
Figur 6 zeigt schematisch eine Vorrichtung zur Detektion elektrischer Spannungen und/oder Ströme in einer ersten Ausführungsform.
Figur 7 zeigt schematisch die Informationen zu den elektrischen Komponenten und den Messsystemen, welche die berechneten Daten beispielhaft umfassen.
Figur 8 zeigt schematisch eine Vorrichtung zur Detektion elektrischer Spannungen und/oder Ströme in einer besonderen Ausführungsform.
Figur 9 zeigt schematisch die Informationen, welche die berechneten Daten zu einem Messgerät gemäß einer Ausführungsform umfassen.
Figur 10 zeigt schematisch eine Vorrichtung zur Detektion elektrischer Spannungen und/oder Ströme in einer weiteren Ausführungsform.
Figur 11 zeigt schematisch eine Vorrichtung zur Detektion elektrischer Spannungen und/oder Ströme in einer wiederum weiteren Ausführungsform.
Figur 12 zeigt schematisch eine Vorrichtung zur Detektion elektrischer Spannungen und/oder Ströme in einer ebenfalls weiteren Ausführungsform.
Figur 13 zeigt eine ausführungsgemäße Detektion einer oder mehrerer elektrischer Spannungen und/oder elektrischer Ströme unter Verwendung einer mobilen Robotereinheit.
Figur 14 zeigt schematisch die Berechnung von aktualisierten berechneten Daten durch ein Verfahren der künstlichen Intelligenz gemäß einer Ausführungsform.
Figur 15 zeigt die Vorrichtungen zur Datenauswertung und Datenspeicherung gemäß einer ersten Ausführungsform.
Figur 16 zeigt die Vorrichtungen zur Datenauswertung und Datenspeicherung gemäß einer weiteren Ausführungsform.
Figur 17 zeigt schematisch eine offenbarungsgemäße Vorrichtung zur automatischen Objekterkennung von spannungstragenden und stromführenden Komponenten.
Figur 18 zeigt schematisch eine offenbarungsgemäße Arbeitsschutzvorrichtung.

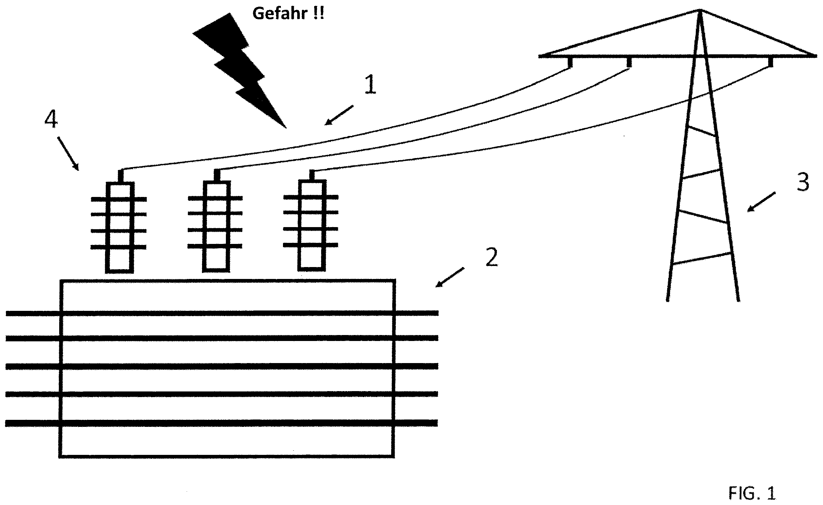

FIG. 1 zeigt schematisch eine Transformatorenstation, wie sie beispielsweise zur Umwandlung von Versorgungsspannungen in elektrischen Versorgungsnetzen Verwendung finden. In einer solchen Transformatorenstation wären beispielsweise die Teile, welche elektrischen Strom führen die elektrischen Leitungen 1 und der Transformator 2. Ein Stromunfall kann hierbei nicht nur durch direkte Berührung mit unter Spannung stehenden oder stromführenden Komponenten verursacht werden, sondern auch infolge eines Lichtbogens, der entstehen kann, wenn eine Person beispielsweise den Hochspannungseingängen 4 am Transformator 2 zu nahekommt.

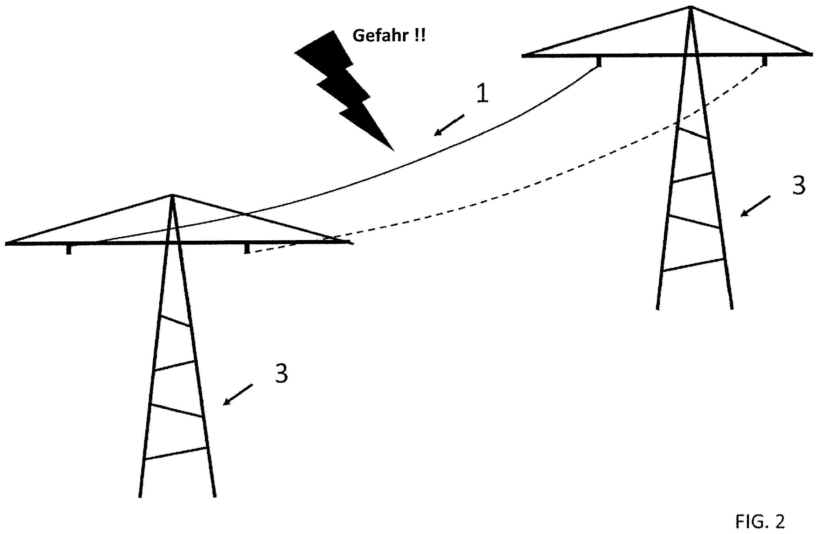

In FIG. 2 ist ein Ausschnitt aus einer Überlandleitung zu dargestellt. Zwischen zwei Überleitungsmasten 3 sind die Hochspannungsleitungen 1 gespannt, welche beispielsweise drei separate Leitungen für die Übertragung von Dreiphasen-Wechselstrom umfassen können. Eine Gefahr für Personen kann beispielsweise darin bestehen, dass wenn im Rahmen von durchzuführenden Arbeiten eine der Leitungen 1 abgeschaltet wird (was in FIG. 2 durch die gestrichelte Leitung dargestellt ist) eine Person irrtümlich der unter Hochspannung stehenden Leitung 1 (in FIG. 2 als durchgehenden Linie dargestellt) zu nahe kommt und es zu einem Lichtbogenunfall kommen kann.

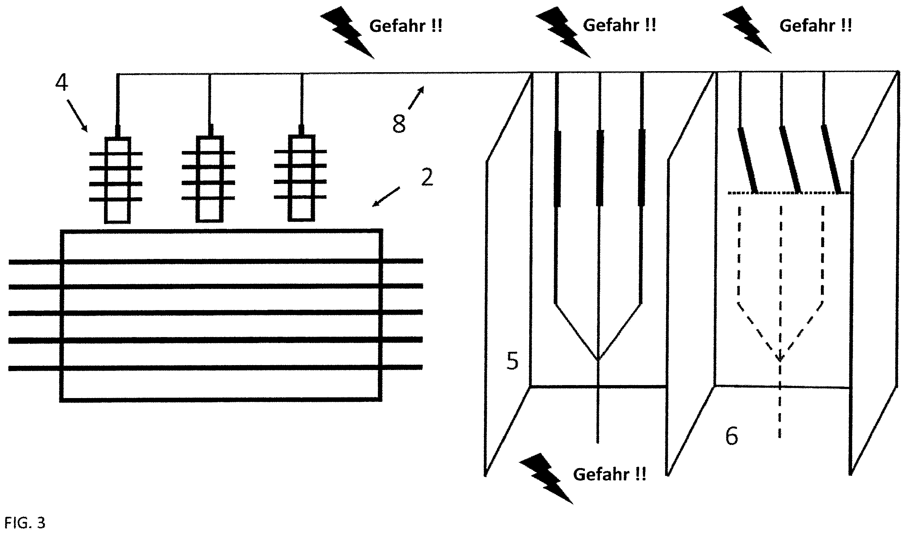

FIG. 3 zeigt eine Transformatorenstation, in welcher zwei Hochvolt-Zellen 5 und 6 durch einen Transformator 2 über eine Sammelschiene 8 versorgt werden. Zelle 5 ist an den Transformator 2 angeschlossen, steht als vollständig unter Spannung, ebenso die Sammelschiene 8, wohingegen Zelle 6 durch einen Schalter vom Transformator 2 abgeklemmt ist, also nur teilweise, d. h. im oberen Zugangsteil unter Spannung steht. Eine Person, welche in der abgeschalteten Zelle 6 Arbeiten zu verrichten hat, kann irrtümlich, etwa im Zuge einer Verwechslung oder Unachtsamkeit, die nichtabgeschaltete, unter Spannung stehende Zelle 5 betreten und dort einen Stromunfall erleiden. Einer rechtzeitig angezeigten Warnung an die betreffende Person, etwa beim Sich-Nähern oder beim Betreten der Zelle 5 angezeigt, kann in diesem Fall eine lebensrettende Bedeutung zukommen. Des Weiteren besteht für die Person die Gefahr, einen Stromunfall durch die oberen unter Strom stehenden Teile der abgeschalteten Zelle 6 zu erleiden

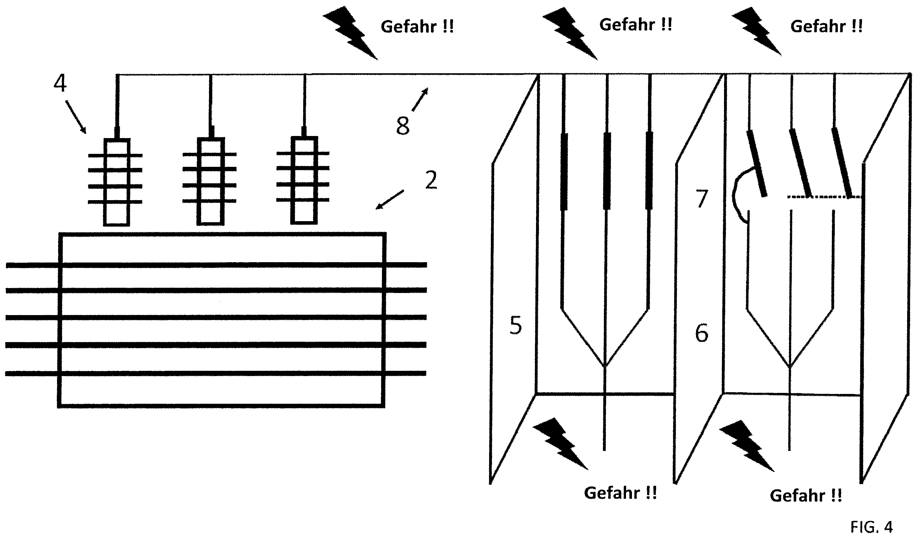

FIG. 4 zeigt die Transformatorenstation aus FIG. 3, bei welcher in der abgeschalteten Zelle 6 ein Defekt 7 aufgetreten ist, wobei der Defekt 7 die Wirkung herbeiführt, dass die Zelle 6 trotz vorgenommener Abschaltung dennoch gänzlich unter Spannung steht. Dies kann für die vorgenannte Person, welche in der eigentlich korrekten Annahme steht, die Zelle 6 stehe im unteren Bereich nicht unter Strom und vorschriftsmäßig durchgeführte Arbeiten stellen somit keine Gefahr dar, zu einer lebensbedrohenden Situation führen, wenn diese defekte Zelle 6 betreten und mit den Arbeiten begonnen wird. Auch in diesem Falle wäre eine rechtzeitige Warnung an die Person von entscheidender Bedeutung.

Solche, beispielhaft gezeigten, vorgenannten Situationen haben für die in solchen Umgebungen arbeitenden oder sich aus anderen Gründen aufhaltenden Personen erhebliche Konsequenzen. Betritt eine Person eine solche, ihr unbekannte Umgebung, so hat diese Person in der Regel zunächst keine Kenntnis, wo sich strom- und spannungsführende Komponenten befinden können und ob eine Bewegung der Person in eine bestimmte Richtung mit Gefahren verbunden sein könnte. Somit kann die Gefahr bestehen, dass die Person diesen Komponenten unbeabsichtigt bei Arbeiten zu nahekommt oder mit diesen in Berührung gerät. Durch ein System mit automatisierter, zuverlässiger und schneller, auf elektrische Komponenten ausgelegte Objekterkennung kombiniert mit einer auf die Person ausgerichteten Bewegungserkennung würden der Person eine geeignete Hilfestellung an die Hand gegeben werden.

Eine schnelle und zuverlässige, automatisierte Objekterkennung von elektrischen Komponenten kann jedoch nicht nur, wie oben bereits erwähnt, bei der Durchführung von Arbeiten an oder in der Nähe dieser Komponenten und der Beurteilung und Einschätzung einer Gefährdungslage und von Gefahrenmustern von Bedeutung sein. Bei Erzeugnissen und Produkten, welche durch die technologischen Entwicklungen der letzten Jahre entstanden sind und in denen elektrische und elektronische Systeme verstärkt zur Anwendung kommen, wie z. B. Elektroautos, Robotersysteme, Solaranlagen, Brennstoffzellen, kann es vorteilhaft sein, sich durch eine schnelle, zuverlässige, automatische Objekterkennung wie etwa einem 3D-Raumscreening Informationen über die Lage von verbauten elektrischen und elektronischen Komponenten zu verschaffen. Hierbei können Umbau-, Erweiterungs- und Wartungsarbeiten schneller und effizienter durchgeführt werden und auch eventuelle Fehlfunktionen sofort erkannt werden. Verfahren und Vorrichtungen, welche ein schnelles und zuverlässiges Bestimmen dieser Strukturen erlauben, würden daher eine entscheidende Hilfestellung anbieten.

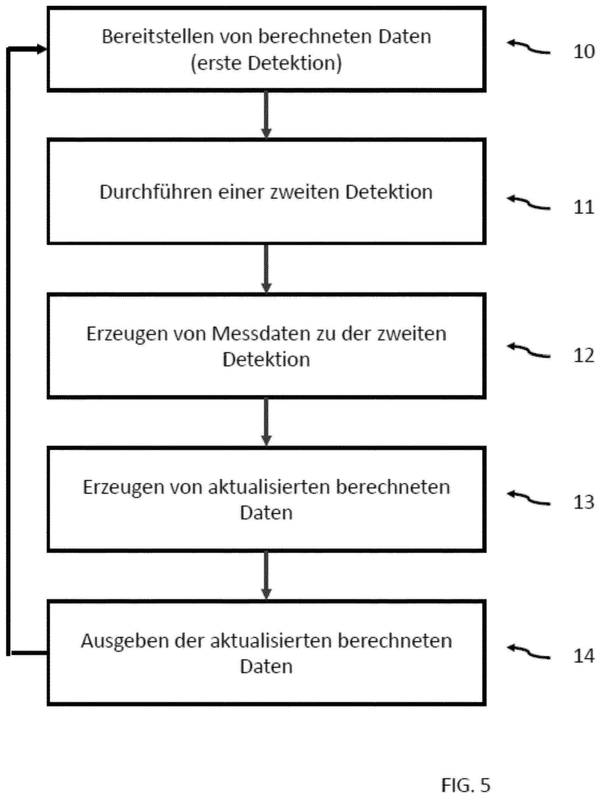

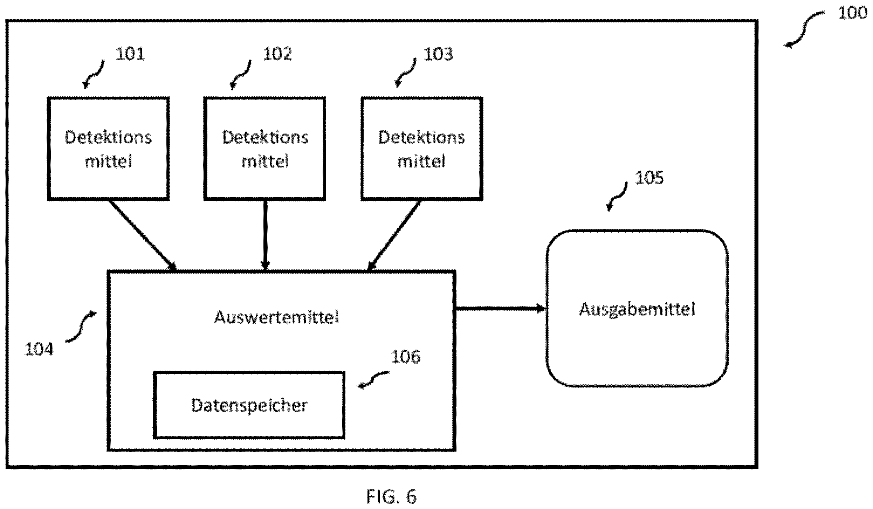

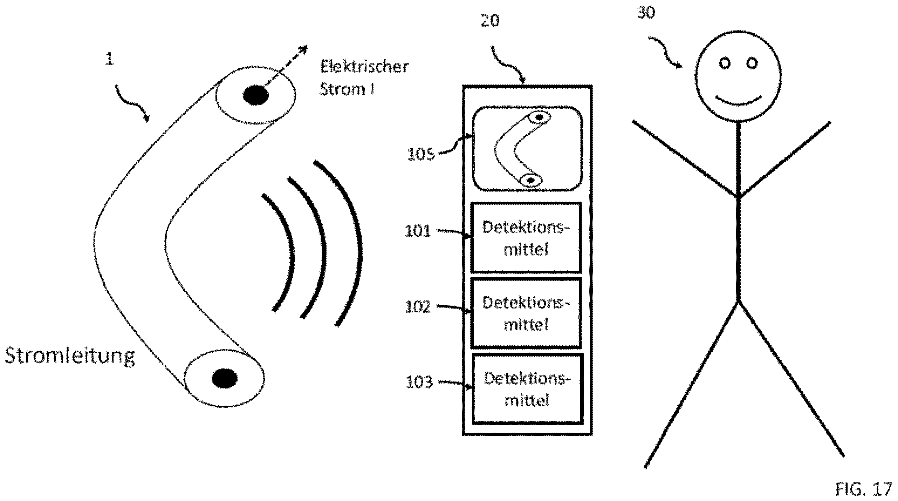

Erfindungsgemäß umfasst das Verfahren das Bereitstellen von berechneten Daten zu ein oder mehreren elektrischen Spannungen und/oder elektrischen Strömen, wie in FIG. 5 im Verfahrensschritt 10 gezeigt. Die berechneten Daten umfassen die räumlichen Positionen mindestens eines Trägers der ein oder mehreren elektrischen Spannungen und/oder der elektrischen Ströme, wie beispielsweise die räumlichen Positionen der stromführenden Leitungen 1 aus den FIG. 1 und 2 oder der Zellen 5 und 6 aus den FIG. 3 und 4. Die elektrischen Ströme können Gleichströme und Wechselströme umfassen. Die berechneten Daten werden aus einem Satz von Messdaten zu einer Mehrzahl erster Detektionen der ein oder mehreren elektrischen Spannungen und/oder der elektrischen Ströme, beispielsweise der Ströme in den Leitungen 1 oder der Zellen 5 und 6 berechnet. Das erfindungsgemäße Verfahren umfasst ferner in einem Verfahrensschritt 11 das Durchführen einer zweiten Detektion der ein oder mehreren elektrischen Spannungen und/oder der elektrischen Ströme, wie der Ströme in den Leitungen 1, wobei in einem Verfahrensschritt 12 bei der zweiten Detektion Messdaten erzeugt werden, und in einem Verfahrensschritt 13 aus den Messdaten der zweiten Detektion und den berechneten Daten aktualisierte berechnete Daten zu den ein oder mehreren elektrischen Spannungen und/oder den elektrischen Strömen, beispielsweise zu den elektrischen Strömen in den Leitungen 1 oder der Zellen 5 und 6 erzeugt werden. Die berechneten Daten als auch die aktualisierten berechneten Daten können in elektronischer und/oder maschinenlesbarer Form vorliegen und in solchen Formaten vorliegen oder konvertiert werden, dass sie von Softwareprogrammen, die etwa vom einem Auswertemittel 104 aus FIG. 6 angewendet werden, gelesen und verarbeitet werden können. Die aktualisierten berechneten Daten werden in einem Verfahrensschritt 14 beispielsweise auf einem Bildschirm, wie dem Bildschirm 105 aus FIG. 17, ausgegeben, um etwa einer Person die räumlichen Positionen und/oder die Eigenschaften des mindestens eines Trägers der ein oder mehreren elektrischen Spannungen und/oder der elektrischen Ströme anzuzeigen.

Das in FIG. 5 gezeigte und vorstehend beschriebene Verfahren kann in mehreren Schritten wiederholt werden, wobei die Anzahl N der Schritte beliebig sein kann. So können bei erneuten zweiten Detektionen zu gegenwärtigen Zeitpunkten aktualisierte berechneten Daten für diese gegenwärtigen Zeitpunkte berechnet werden. Die Angabe der Lage von stromführenden und spannungstragenden Objekten und Komponenten kann somit immer auf gegenwärtige Zeitpunkte ausgerichtet sein. Eine in der Umgebung solcher stromführenden und spannungstragenden Objekte und Komponenten arbeitende Person ist somit immer im Besitz von aktuellen und damit verlässlichen Angaben zu den Lagen solcher Objekte und Komponenten.

Die Mehrzahl der ersten Detektionen kann hierbei in einem von der zweiten Detektion gänzlich separierten Verfahren durchgeführt werden. Zusätzlich kann die Mehrzahl der ersten Detektionen mit einer anderen Messvorrichtung als bei der zweiten Detektion durchgeführt werden. Die erste und die zweite Detektion können zu verschiedenen Zeitpunkten durchgeführt werden.

Wie nachstehend ausgeführt, kann in einer Ausführungsform die Berechnung des aktualisierten Satzes von berechneten Daten unter Verwendung selbstlernender Systeme und künstlicher Intelligenz erfolgen.

Erfindungsgemäß umfasst das Verfahren weiter die Bereitstellung einer Mehrzahl von Detektionsmitteln zur Detektion einer Mehrzahl von Messgrößen, wobei die Mehrzahl der Messgrößen Eigenschaften der ein oder mehreren elektrischen Spannungen und/oder elektrischer Ströme, wie beispielsweise der elektrischen Ströme in den Leitungen 1 der FIG. 1 und 2 oder in den Zellen 5 und 6 in den FIG. 3 und 4, bestimmen und wobei mindestens eine Messgröße die Eigenschaften elektrischer und/oder magnetischer und/oder elektromagnetischer Felder quantitativ bestimmt. Aus mindestens einer Messgröße werden die räumlichen Positionen oder Lagen des mindestens einen Trägers der ein oder mehreren elektrischen Spannung und/oder des elektrischen Stroms, wie beispielsweise die räumlichen Positionen der Leitungen 1 oder der Zellen 5 und 6 bestimmt, und aus mindestens einer Messgröße die räumlichen Positionen der Mehrzahl der Detektionsmittel, wobei die Detektionsmittel an einem beweglichen Träger wie einer Person angebracht sein können. Wie untenstehend näher ausgeführt, können die räumlichen Positionen auch Bewegungszustände umfassen.

In FIG. 6 ist die Bereitstellung einer Mehrzahl von Detektionsmitteln 101, 102 und 103 durch eine erfindungsgemäße Vorrichtung 100 schematisch gezeigt. Beispielsweise können die Detektionsmittel 101 und 102 Messgrößen im Zusammenhang mit elektrischen und/oder magnetischen und/oder elektromagnetischen Felder detektieren, welche beispielsweise auf das Vorhandensein von elektrischen Spannungen und Strömen in den Leitungen 1 oder der Zellen 5 und 6 hindeuten. Aus diesen Messgrößen können dann die räumlichen Positionen und Lagen der elektrischen Leitungen 1 oder der Zellen 5 und 6 bestimmt werden. Aus den vorgenannten Messgrößen können physikalische Größen wie Stromstärke und Spannung bestimmt werden Aber auch das Vorhandensein von nicht vorgesehenen elektrischen Spannungen bei Defekten und Fehlfunktionen, wie diese z. B. im Falle der Fehlfunktion 7 bei der Abschaltung der Zelle 6 in FIG. 4 vorkommen, kann detektiert werden. Die Detektionsmittel 101 und 102 können auf diese Weise Schäden an elektrischen Anlagen oder deren eventuelle Fehlfunktionen detektieren, welche etwa schematisch durch die Fehlfunktion 7 in der abgeschalteten Zelle 6 in der FIG. 4 dargestellt sind.

Die Detektionsmittel 101, 102 und 103 können aber auch Messgrößen, welche auf Umgebungsbedingungen hindeuten, detektieren, wie z. B. den Luftdruck, welcher in der Umgebung der Leitungen 1 herrscht. Weiterhin kann in der erfindungsgemäßen Vorrichtung 100 beispielsweise das Detektionsmittel 103 eine Messgröße im Zusammenhang mit der räumlichen Position und/oder eines Bewegungszustandes der Vorrichtung 100 oder zumindest eines der Detektionsmittel 101 oder 102 detektieren. Daraus können dann die entsprechenden räumlichen Positionen und/oder die Bewegungszustände der Vorrichtung 100 und der Detektionsmittel 101, 102 und 103 bestimmt werden. So kann beispielsweise bestimmt werden, in welcher Höhe sich eine Person am Überleitungsmast 3 gerade befindet, wenn diese Person den Überleitungsmast 3 gerade hinaufklettert und die Vorrichtung 100 mit sich führt. Auf diese Weise kann auch der Abstand bestimmt werden, welche die Person zu den Leitungen 1 momentan besitzt.

Erfindungsgemäß umfasst, wie in FIG. 6 gezeigt, das Verfahren das Bereitstellen mindestens eines Auswertemittels 104, um aus der Mehrzahl von Messgrößen Messdaten, beispielsweise zu den räumlichen Positionen des mindestens einen Trägers der ein oder mehreren elektrischen Spannungen und/oder der elektrischen Ströme und/oder zu den räumlichen Positionen und/oder den Bewegungszuständen der Mehrzahl der Detektionsmittel, wie etwa der Detektionsmittel 101, 102 und 103 zu erzeugen.

Erfindungsgemäß umfasst die Vorrichtung weiter die Bereitstellung eines Ausgabemittels 105, um ein mindestens ein Ausgabesignal zu erzeugen, wobei das mindestens eine Ausgabesignal basierend auf den berechneten Daten und den Messdaten der zweiten Detektion und/oder den aktualisierten berechneten Daten erzeugt wird. In einer Ausführungsform ist das Ausgabemittel 105 in die Vorrichtung integriert, wie in FIG. 6 schematisch gezeigt, und kann etwa einen Lautsprecher umfassen, welcher ein akustisches Warnsignal ausgibt, wenn eine Person stromführenden Leitungen 1 oder Zellen 5 und 6 zu nahekommt.

In einer weiteren erfindungsgemäßen Ausführungsform kann das Ausgabemittel 105 einen Bildschirm umfassen, auf welchen die räumliche Lage der in der Umgebung vorhandenen spannungstragenden und stromführenden Komponenten angezeigt wird (siehe hierzu Bildschirm 105 der FIG. 17), wie etwa die Leitungen 1 in den FIG. 1 und 2 oder die Zellen 5 und 6 in den FIG. 3 und 4.

Die Vorrichtung 100 kann in einer Ausführungsform einen Speicher zur Speicherung von Daten 106 umfassen, wie untenstehend näher ausgeführt wird.

Die Errechnung der Lage sowie der technischen und physikalischen Eigenschaften der Komponenten wie etwa den Leitungen 1 oder den Zellen 5 und 6 erfolgt beispielsweise durch die Vorrichtung 100, etwa unter Verwendung des Auswertemittels 104, auf der Grundlage der berechneten Daten und den Messdaten der zweiten Detektion. In einer Ausführungsform können die berechneten Daten der Vorrichtung 100 und/oder dem Auswertemittel 104 zur Verfügung stehen, ohne dass die Vorrichtung 100 und/oder das Auswertemittel 104 weitere Berechnungen in Bezug auf die berechneten Daten durchführen muss.

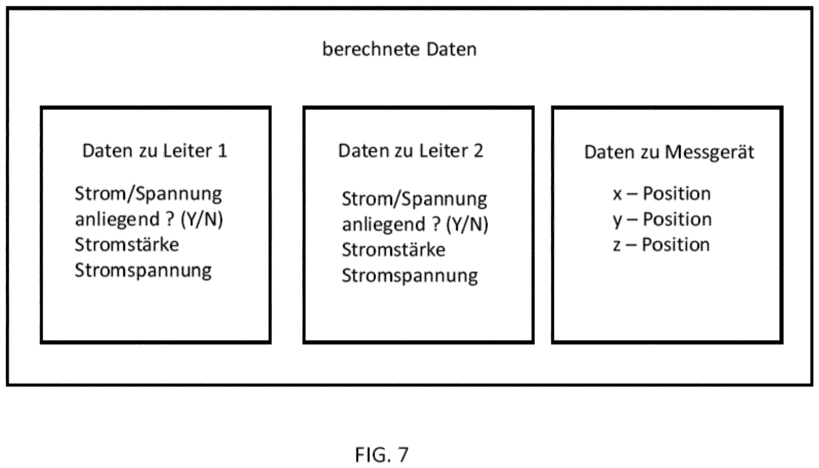

In einer Ausführungsform können die berechneten Daten und/oder die aktualisierten berechneten Daten weitere Eigenschaften der in den Trägern vorhandenen elektrischen Spannungen und/oder der elektrischen Ströme umfassen. In FIG. 7 sind beispielhaft einige weitere Eigenschaften gezeigt, welche umfasst sind. Dies sind etwa die entsprechenden Stromstärken und Stromspannungen, welche an den Leitungen 1 und der nicht abgeschalteten Zelle 5 anliegen. In FIG. 7 enthalten die berechneten Daten zu einem Messgerät, etwa der Vorrichtung 100, neben den Daten zur räumlichen Position keine weiteren zusätzlichen Daten zu weiteren Eigenschaften. In anderen Ausführungsformen können die berechneten Daten zu dem Messgerät aber solche zusätzlichen Daten ebenfalls enthalten, wie etwa Daten zu den Umgebungsbedingungen der Leiter.

In einer Ausführungsform kann mindestens eine Messgröße eine Feldstärke, eine Flussdichte, eine Änderung der Feldstärke, eine Änderung der Flussdichte, eine Kapazität, einen mit dem Vorhandensein der ein oder mehreren elektrischen Spannungen und/oder Ströme verbundenen Schall und/oder eine zeitliche und/oder räumliche Änderung der vorgenannten Messgrößen und/oder aus den vorgenannten Messgrößen abgeleitete Messgrößen umfassen.

In einer weiteren Ausführungsform kann die mit den räumlichen Positionen der Mehrzahl der Detektionsmittel 101, 102 und 103 verbundene mindestens eine Messgröße das an den räumlichen Positionen der Mehrzahl der Detektionsmittel 101, 102 und 103 auftretende Erdmagnetfeld und/oder den an den räumlichen Positionen der Mehrzahl der Detektionsmittel 101, 102 und 103 auftretenden Luftdruck und/oder an räumlichen Positionen der Mehrzahl der Detektionsmittel auftretenden Ultraschall bestimmen.

In einer erfindungsgemäßen Ausführungsform kann, wie bereits genannt, das Detektionsmittel eine Vorrichtung zum Messen des Umgebungsluftdruckes umfassen. So kann beispielsweise über die Messung eines höhenanhängigen Luftdruckes die Höhe bestimmt werden, in welcher sich eine Person gerade befindet, wenn diese etwa einen der Leitungsmasten 3 in der FIG. 3 emporklettert, um beispielsweise Arbeiten an dem Leitungsmasten 3 zu verrichten. Sollte herbei der Höhenluftdruck anzeigen, dass eine gewisse Höhe überschritten wurde und dass die Person den stromführenden Leitungen 1 zu nahe zu kommen droht und etwa die Gefahr eines Lichtbogens besteht, dann kann über das Ausgabemittel 105 der Person eine Warnung angezeigt werden.

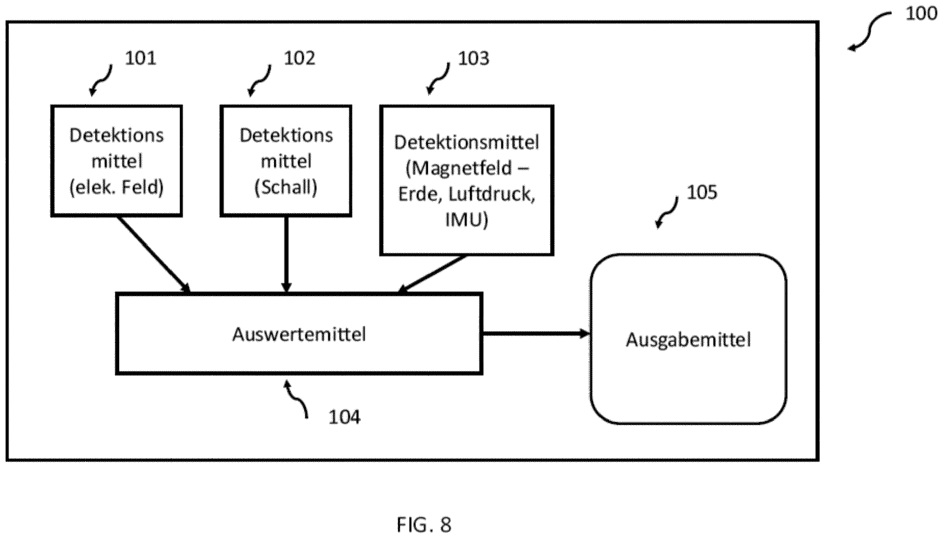

Beispielhaft umfasst in FIG. 8 die durch das Detektionsmittel 101 detektierte Messgröße ein durch ein von Kapazitäten in einer Gleichstromanlage (z. B. Batterie, Brennstoffzelle, Solaranlage) hervorgerufenes elektrisches Feld. Ein elektrisches Feld kann aber auch von einer Spannung erzeugt werden, welche aufgrund einer Fehlfunktion oder eines Schadens an einer Komponente, etwa des Defektes 7 in der abgeschalteten Zelle 6, anliegt. Weiterhin umfasst beispielhaft die durch das Detektionsmittel 102 detektierte Messgröße einen Schalldruck, wie er etwa durch den Körperschall einer von elektrischem Strom durchflossenen Komponente (z. B. einem Elektromotor) erzeugt wird. Die beispielhaft durch das Detektionsmittel 102 detektierte Messgröße kann aber auch das durch den elektrischen Strom erzeugte Magnetfeld umfassen. Des Weiteren kann beispielsweise die durch das Detektionsmittel 103 detektierte Messgröße eine durch das Erdmagnetfeld induzierten Stromfluss umfassen oder aber die Position einer mit dem Detektionsmittel 103 verbundenen Antenne im Rahmen einer GPS basierten Positionsbestimmung. Das Detektionsmittel 103 kann aber auch Messgrößen zum Umgebungsluftdruck oder zu IMU-Daten umfassen.

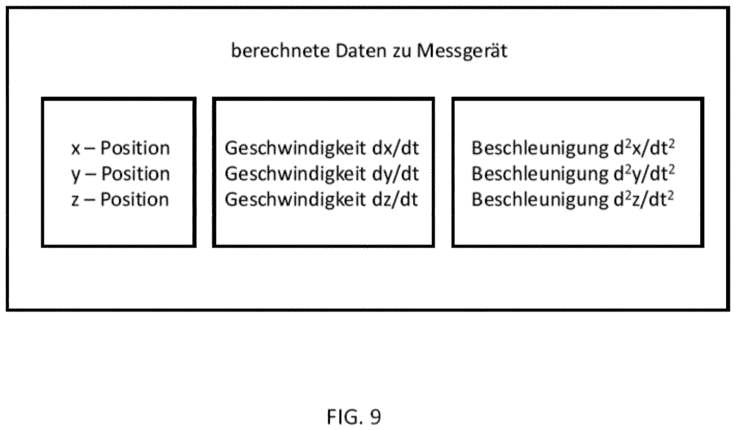

In einer Ausführungsform können die berechneten Daten zusätzlich, wie es schematisch in FIG. 9 gezeigt ist, die räumliche Bewegung und/oder die Beschleunigung der Mehrzahl der Detektionsmittel umfassen. Die räumliche Bewegung kann translatorische und rotatorische Komponenten umfassen. Die räumliche Bewegung ist die erste Ableitung der räumlichen Position nach der Zeit, umfasst also verschiedenen räumliche Positionen der Detektionsmittel zu verschiedenen Messzeitpunkten und die Beschleunigung ist die zweite Ableitung der räumlichen Position nach der Zeit, umfasst also die Differenz zwischen zwei räumlichen Positionen, welche zu der Differenz der entsprechenden Messzeitpunkte auftritt. In einer Ausführungsform kann die räumliche Bewegung und die Beschleunigung unter Verwendung der Orientierung der Vorrichtung 100 und/oder der Detektionsmittel 101, 102, 103 zum Gravitationsvektor bestimmt werden. Die Detektionsmittel 101, 103, 103 können in einer anderen Ausführungsform auch Bewegungs- und Beschleunigungssensoren umfassen, die beispielsweise auf MEMS-Technologie beruhen oder Gyrometer oder piezoelektrische Elemente umfassen.

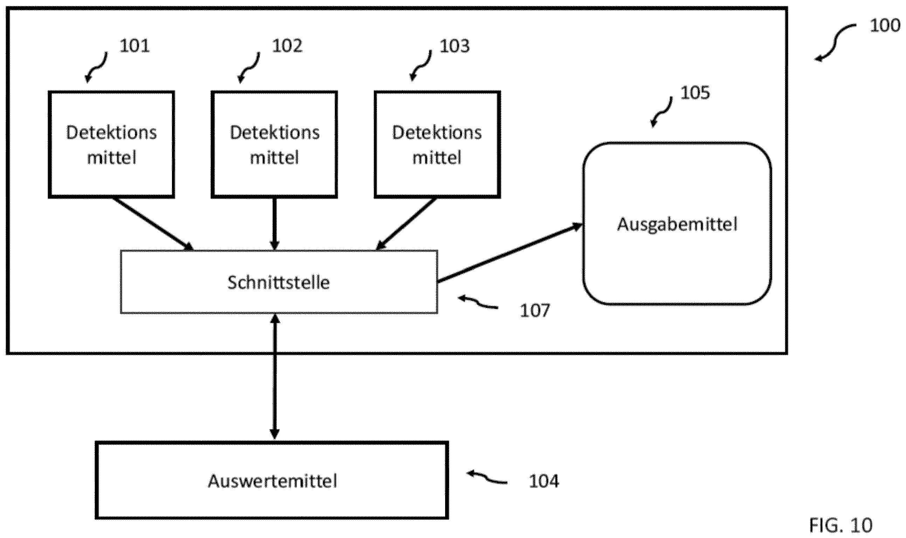

In einer Ausführungsform kann das Auswertemittel 104 einen programmgesteuerten Rechner umfassen, der in die erfindungsgemäße Vorrichtung 100 integriert ist. In einer anderen Ausführungsform kann das Auswertemittel 104 in der Vorrichtung 100 integriert sein, wie in FIG. 6 gezeigt, und in einer wieder anderen Ausführungsform kann das Auswertemittel 104 sich an einem von der Vorrichtung 100 entfernten Standort befinden, beispielsweise an einer zentralen Serverstation. In FIG. 10 ist schematisch diejenige Ausführungsform gezeigt, in welcher sich das Auswertemittel 104 an einem von der Vorrichtung 100 entfernten Standort befindet. In dieser Ausführungsform kann die Vorrichtung 100 eine Schnittstelle 107 umfassen, über welche Daten, wie etwa Messdaten, von der Vorrichtung 100 zu dem Auswertemittel 104 übertragen werden. Die Übertragung kann drahtgebunden und/oder drahtlos erfolgen. Eine drahtlose Übertragung kann beispielsweise über Funk oder über Infrarotstrahlung ausgeführt werden. Die Schnittstelle 107 kann auch dazu verwendet werden, die aus den Messdaten erzeugten berechneten Daten an die Vorrichtung 100 zu übertragen, um beispielsweise die örtlichen Positionen der Leitungen 1 oder die Position eines Trägers der Vorrichtung 100 anzuzeigen oder eine Warnung auszugeben.

Über die Schnittstelle 107 können aber auch andere Daten an die Vorrichtung 100 übertragen werden, wie etwa Anweisungen an den Träger der Vorrichtung 100 oder Aktualisierungen von Betriebssoftware.

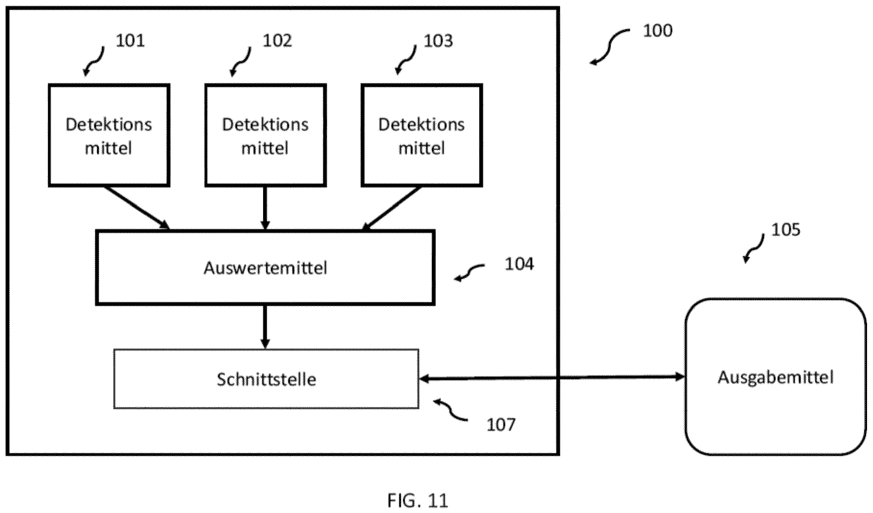

In einer anderen, in FIG. 11 schematisch dargestellten Ausführungsform kann sich das Ausgabemittel 105 an einem von der Vorrichtung 100 entfernten Standort befinden, etwa an den Standort, an den sich das für eventuelle Reparatur- und Wartungsarbeiten Personal befindet, wohingegen die Vorrichtung 100 sich beispielsweise auf einer ferngesteuerten oder sich autonom bewegenden, mobilen Robotereinheit befindet. Über die Schnittstelle 107 können Daten zwischen der Vorrichtung 100 und dem Ausgabemittel 105 übertragen werden. Die Übertragung kann drahtgebunden und/oder drahtlos erfolgen. Eine drahtlose Übertragung kann beispielsweise über Funk oder über Infrarotstrahlung ausgeführt werden.

In einer Ausführungsform umfasst das Ausgabemittel 105 einen Bildschirm, um etwa die Lage derjenigen Komponenten in einer betreffenden Umgebung anzuzeigen, welche elektrische Spannungen tragen oder elektrische Ströme führen. In einer anderen Ausführungsform kann das Anzeigemittel 105 ein Head-up-Display umfassen, welches beispielsweise an einem Helm, wie einem Sicherheitshelm montiert ist. In ein derartiges Head-Up-Display kann beispielsweise die Lage der spannungstragenden und stromführenden Komponenten als dreidimensionale Struktur (3D) hineinprojiziert werden, welches sich mit der durch das Head-Up-Display sichtbaren Umgebung überlappt. In einer weiteren Ausführungsform kann das Anzeigemittel 105 einen Lautsprecher umfassen, der beispielsweise ein akustisches Warnsignal ausgibt. In einer anderen Ausführungsform kann das Anzeigemittel 105 eine Vibrationseinheit zur Ausgabe eines haptischen Signals umfassen. In einer weiteren Ausführungsform kann das Anzeigemittel 105 eine Kombination der vorgenannten Ausführungsformen umfassen.

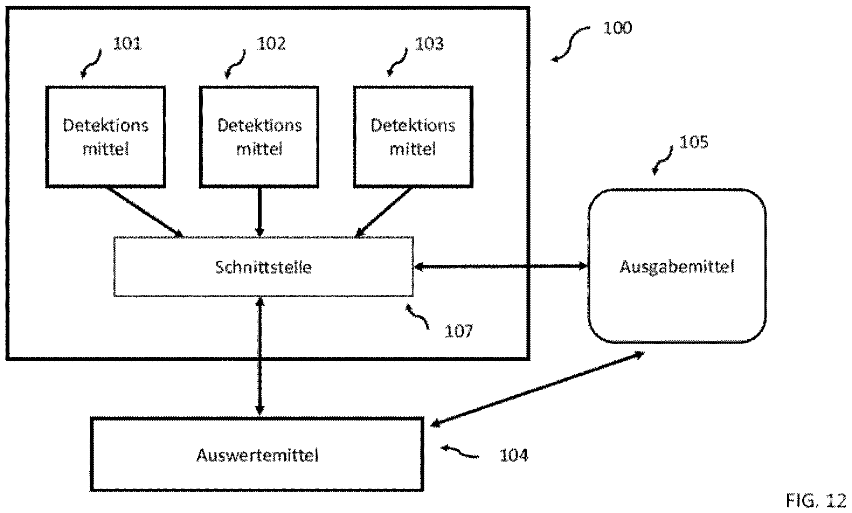

In einer weiteren Ausführungsform können sowohl das Auswertemittel 104 als auch das Ausgabemittel 105 in von der Vorrichtung 100 entfernten Orten befinden, wie in FIG. 12 schematisch dargestellt. Über die Schnittstelle 107 können hierbei Daten zwischen der Vorrichtung 100 und dem Auswertemittel 104 und/oder dem Ausgabemittel 105 übertragen werden. Die Übertragung kann drahtgebunden und/oder drahtlos erfolgen. Eine drahtlose Übertragung kann beispielsweise über Funk oder über Infrarotstrahlung ausgeführt werden. Die Schnittstelle 107 kann für die Übertragung ein drahtgebundenes oder drahtloses Local Area Network (LAN) oder ein drahtgebundenes oder drahtloses Metropolitan Area Network (MAN) oder ein drahtgebundenes oder drahtloses Wide Area Network (WAN) wie das Internet oder eine Kombination der vorgenannten Netzwerktechnologien nutzen. Die vorgenannten Netzwerktechnologien werden durch geeignete Kommunikations- und Netzwerkprotokolle implementiert.

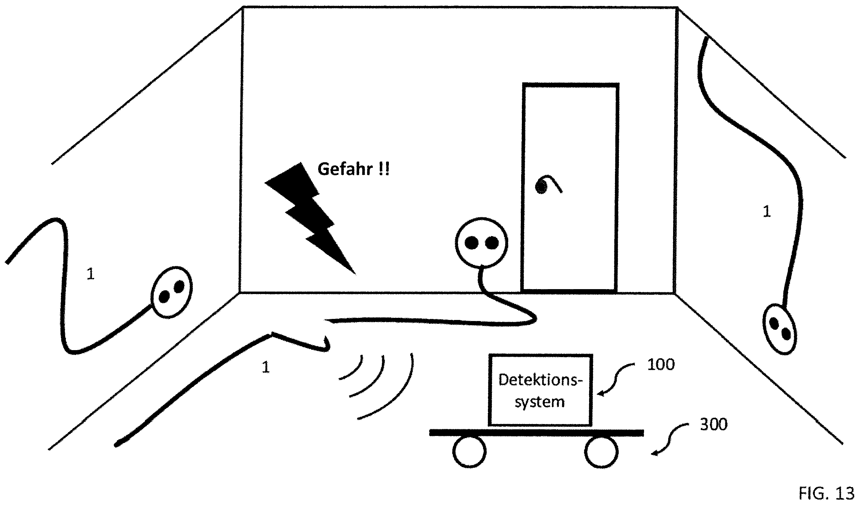

Wie zuvor bereits ausgeführt, ist in einer Ausführungsform mit den räumlichen Positionen der Mehrzahl der Detektionsmittel 101, 102, 103 verbundene mindestens eine Messgröße zusätzlich die Bestimmung der räumlichen Bewegung und/oder der Beschleunigung der Mehrzahl der Detektionsmittel 101, 102, 103 umfasst. Eine räumliche Bewegung und/oder Beschleunigung kann beispielsweise durch eine Bewegung der Person erfolgen, an dem die Mehrzahl der Detektionsmittel 101, 102 und 103 befestigt ist. Die räumliche Bewegung und/oder Beschleunigung kann aber auch beispielsweise durch eine mobile, ferngesteuerte oder sich autonom bewegende Robotereinheit, wie sie beispielsweise schematisch in FIG. 13 durch die Robotereinheit 300 dargestellt ist und an der die Vorrichtung 100 zusammen mit Mehrzahl der Detektionsmittel 101, 102 und 103 (in FIG. 13 nicht gezeigt) befestigt ist, erfolgen. Eine Beschleunigung kann, wie bereits genannt, beispielsweise mittels auf MEMS-Technologie basierenden Beschleunigungssensoren, mittels Gyroskope und piezoelektrischen Sensoren gemessen werden.

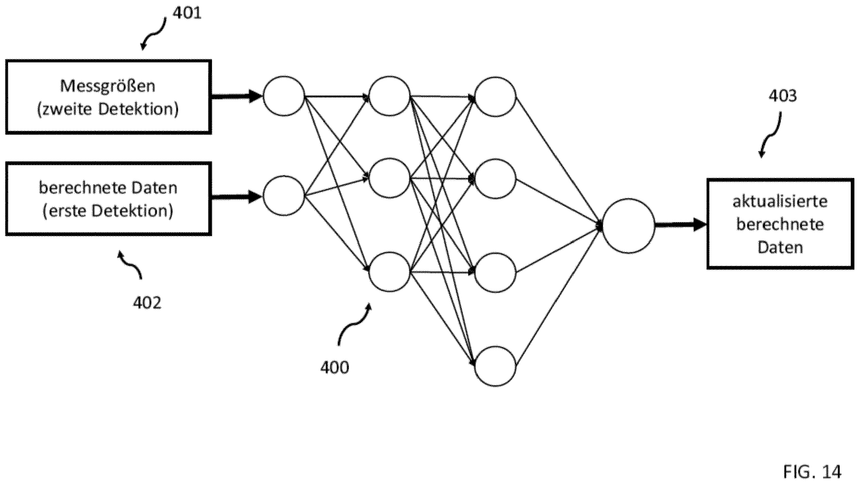

Erfindungsgemäß umfasst das Verfahren weiter die Berechnung und Aktualisierung der berechneten Daten mit auf künstlicher Intelligenz basierenden Verfahren, wie beispielsweise auf maschinellem Lernen basierenden Verfahren, wobei der Satz von Messdaten zu einer Mehrzahl erster Detektionen als Trainingsdaten für die auf maschinellem Lernen basierenden Verfahren verwendet werden. In FIG. 14 ist die Berechnung von aktualisierten berechneten Daten 403 schematisch dargestellt. Die in der zweiten Detektion ermittelten aktuellen Messgrößen 401 dienen zusammen mit den aus früheren, ersten Detektionen berechneten Daten 402 als Eingabedaten für ein auf künstlicher Intelligenz wie maschinellen Lernen basierendem Verfahren, welches in FIG. 14 schematisch durch das System 400 dargestellt ist. Das von System 400 angewendete Verfahren kann auf Lernalgorithmen basieren, die aus überwachtem Lernen, halbüberwachtem Lernen, unbeaufsichtigtem Lernen, Verstärkungslernen, Lernen von Merkmalen, auch Lernen mit wenigen Wörterbüchern, Erkennung von Anomalien, Lernen mit Entscheidungsbäumen, Lernen mit Assoziationsregeln usw. bestehen können. In einigen weiteren Ausführungsformen basiert der Algorithmus des maschinellen Lernens auf Support-Vektor-Maschinen, Bayes-Netzwerken, genetischen Algorithmen usw.

Die durch Verfahren der künstlichen Intelligenz wie maschinellem Lernen gewonnenen berechneten Daten und/oder aktualisierten berechneten Daten werden in einer Ausführungsform zur Erkennung von stromführenden und spannungstragenden Objekten, der Lage von stromführenden und spannungstragenden Objekten und Komponenten in einer Umgebung, aber auch zur Erkennung von mit diesen Objekten und Komponenten verbundene Eigenschaften wie Gleichstrom oder Wechselstrom, zur Erkennung der Umgebung der Objekte oder zur Erkennung von Schäden verwendet. Die berechneten Daten und/oder aktualisierten berechneten Daten werden auch zu Bestimmung des Bewegungszustandes der Vorrichtung 100 oder der Detektionsmittel 101, 102 und 103 verwendet. Die berechneten Daten und/oder aktualisierten berechneten Daten werden in einer anderen Ausführungsform auch zur Erzeugung des Ausgabesignals wie etwa eines Warnsignals verwendet.

In einer Ausführungsform ist der Rechner von einer von der Vorrichtung 100 entfernten Rechnerplattform umfasst, so dass die Vorrichtung 100 zur Detektion von ein oder mehreren elektrischen Strömen und/oder elektrischen Spannungen nur die berechneten Daten und/oder die aktualisierten berechneten Daten verwendet und diese nicht selbst berechnet.

In einer anderen Ausführungsform kann das System 400 einen zentralen Rechner umfassen, wobei dieser Rechner von dem Auswertemittel 104 umfasst sein kann. In einer anderen Ausführungsform kann das System 400 auch ein verteiltes Rechnersystem umfassen, die durch ein Netzwerk miteinander verbunden sind.

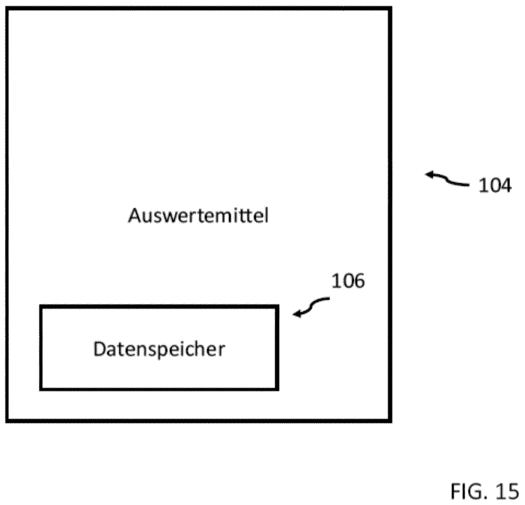

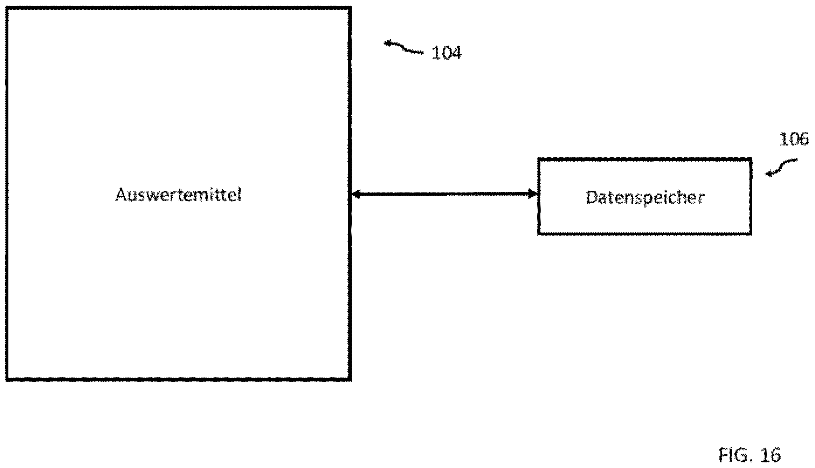

Erfindungsgemäß umfasst das Verfahren weiter die Speicherung der berechneten Daten in einer Vorrichtung zur Speicherung von Daten. Die Vorrichtung zur Speicherung von Daten kann als Datenspeicher 106 ausgeführt sein, der Bestandteil des Auswertemittels 104 ist, wie schematisch in FIG. 15 gezeigt ist. In einer anderen Ausführungsform, wie in FIG. 16 schematisch gezeigt, dann der Datenspeicher 106 als von dem Auswertemittel 104 separate Einheit ausgeführt sein. Die Übertragung der berechneten Daten und anderer Daten kann hierbei drahtgebunden und/oder drahtlos erfolgen. Eine drahtlose Übertragung kann beispielsweise über Funk oder über Infrarotstrahlung ausgeführt werden. Es kann für die Übertragung ein drahtgebundenes oder drahtloses Local Area Network (LAN) oder ein drahtgebundenes oder drahtloses Metropolitan Area Network (MAN) oder ein drahtgebundenes oder drahtloses Wide Area Network (WAN) wie das Internet oder eine Kombination der vorgenannten Netzwerktechnologien verwendet werden. Die vorgenannten Netzwerktechnologien werden durch geeignete Kommunikations- und Netzwerkprotokolle implementiert.

Erfindungsgemäß tauscht der Datenspeicher 106 kann mit den Auswertemittel 104 Daten aus, wie in FIG. 16 gezeigt. In einer Ausführungsform kann der Datenspeicher 106 auch mit jeder anderen Komponente der Vorrichtung 100 Daten austauschen.

Zu dem Datenspeicher 106 können flüchtige und nicht flüchtige sowie entfernbare und nicht entfernbare materielle Medien gehören, die in einer beliebigen Methode oder Technologie zur Speicherung von Informationen implementiert sind, wie z.B. computerlesbare Anweisungen, Datenstrukturen, Programmmodule oder andere Daten. Zu den computerlesbaren Speichermedien können ferner Speicher mit wahlfreiem Zugriff (RAM), Festwertspeicher (ROM), löschbare programmierbare Festwertspeicher (EPROM), elektrisch löschbare programmierbare Festwertspeicher (EEPROM), Flash-Speicher oder andere Festkörperspeichertechnologien, tragbare Compact-Disc-Festwertspeicher (CD-ROM) oder andere optische Speicher, Magnetkassetten, Magnetbänder, Magnetplattenspeicher oder andere magnetische Speichergeräte oder jedes andere Medium gehören, das zur Speicherung der gewünschten Informationen verwendet werden kann und das von einem Computer gelesen werden kann.

In einer besonderen Ausführungsform kann die Vorrichtung zur Speicherung von Daten eine Cloud, unter welcher eine Rechnerwolke oder Datenwolke verstanden werden kann, umfassen.

Erfindungsgemäß umfasst das Ausgabesignal in einer Ausführungsform Angaben über die räumlichen Positionen oder die Lage des Trägers der elektrischen Spannungen und/oder der elektrischen Ströme. Das Ausgabesignal kann beispielsweise eine optische oder akustische Warnanzeige sein, dass sich in der Nähe einer Person eine stromführende oder spanungstragender Komponente befindet. So kann etwa ein akustisches Warnsignal ausgegeben werden, wenn sich die betreffende Person, wie obenstehend bereits ausgeführt, beispielsweise im Rahmen von Montage- und Wartungsarbeiten versehentlich die nicht abgeschaltete Zelle 5 der Transformatorenanlage in FIG. 3 betritt und mit elektrisch geladenen Komponenten in Berührung zu kommen droht. In einem anderen Beispiel können Warnsignale ausgegeben werden, wenn elektrischen Komponenten in einem Elektroauto oder einer Solaranlage zu nahegekommen wird.

Das Warnsignal kann ausgegeben werden, wenn beispielsweise in einem oben beschriebenen Verfahren der künstlichen Intelligenz die Auswertung der Messdaten und der berechneten Daten ergeben hat, das ein erforderlicher Mindestabstand einer Person zu einer gefährdenden elektrischen Komponente unterschritten worden ist. Die Ausgabe der Warnsignale kann hierbei abgestuft erfolgen. So kann zuerst ein Anfangsalarm ausgegeben werden. Nähert sich die Person dennoch weiter der gefährdenden Komponente, so kann ein Steigerungsalarm ausgegeben werden. Reagiert die betreffende Person immer noch nicht und nähert sich weiter der betreffenden gefährdenden Komponente, so kann schließlich ein intensiver Daueralarm ausgegeben werden.

Beispielsweise kann das Warnsignal ein akustisches Signal wie einen Brummton, ein Piepton oder ein Sirenensignal umfassen, welches durch einen Lautsprecher erzeugt wird. Alternativ kann das Warnsignal ein optisches Signal umfassen, wie etwa das Aufleuchten einer LED oder die Ausgabe eines optischen Warnsignals auf einem Bildschirm wie etwa ein rotes Leuchtsignal oder die Ausgabe des Wortes "GEFAHR!", "ACHTUNG!", "VORSICHT!" oder "DANGER!". Das Warnsignal kann auch ein haptisches Signal umfassen, etwa wenn das Gerät direkt am Körper getragen wird. In einer anderen Ausführungsform können auch mehrere verschiedene Warnsignale redundant ausgegeben werden.

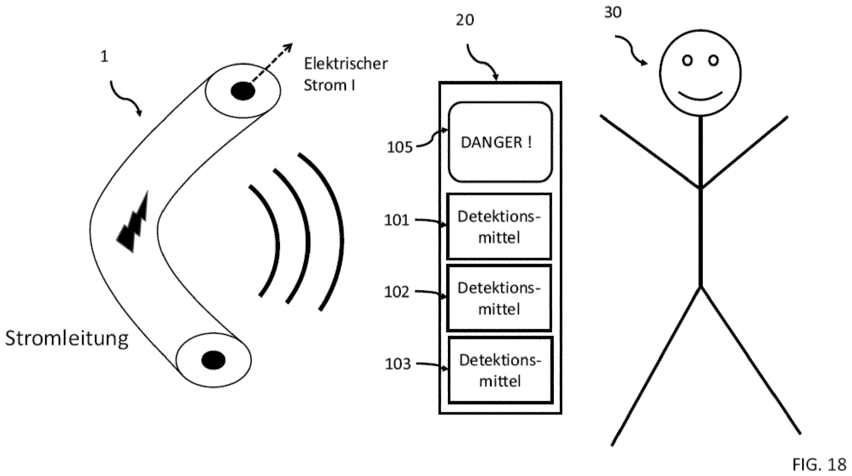

Erfindungsgemäß ist eine Vorrichtung zum Detektieren von ein oder mehreren elektrischen Spannungen und/oder elektrischen Strömen in einer Anzeigevorrichtung, wie in FIG. 17 und 18 dargestellt, umfasst. Die Anzeigevorrichtung ist in einer erfindungsgemäßen Ausführungsform ein tragbares Gerät 20, welches von einer Person 30, etwa einem Angehörigen des technischen Personals, mitgeführt wird und beim Auftreten von ein oder mehreren elektrischen Spannungen und/oder elektrischen Strömen eine Darstellung der Lage der Träger dieser ein oder mehreren elektrischen Spannungen und/oder Ströme in der entsprechenden Umgebung ausgibt, wie in FIG. 17 gezeigt. In einer Ausführungsform kann die Darstellung hierbei eine 3D-Darstellung umfassen. Es kann auch ein Warnsignal ausgegeben werden, wie in FIG. 18 gezeigt. In einer besonderen Ausführungsform kann das tragbare Gerät 20 von der Person 30 direkt am Körper getragen werden, beispielsweise mittels eines Armbandes oder eines Stirnbandes. In einer erfindungsgemäßen Ausführungsform umfasst das Gerät 20 als Ausgabemittel 105 einen Bildschirm und als Ausgabesignal ein Textsignal, in FIG. 18 beispielhaft durch das Wort "DANGER!" dargestellt, auf. Es können aber auch andere Wörter wie "GEFAHR!", "ACHTUNG!" oder "VORSICHT!" angezeigt werden. In weiteren Ausführungsformen kann ein akustisches Warnsignal, beispielsweise ein hoher Piepton oder ein haptisches Signal, etwa wenn die Person 30 das Gerät 20 direkt am Körper trägt, ausgegeben werden. In einer anderen Ausführungsform können auch mehrere verschiedene Warnsignale redundant ausgegeben werden.

In einer weiteren Ausführungsform kann das Gerät 20 ein Smartphone oder eine Smartwatch umfassen, welche das Auswertesignal 11 mittels einem auf Bluetooth basierendem Übertragungssystem empfängt und auf einem Bildschirm als Ausgabesignal beispielsweise ein oben beschriebenes Textsignal oder jedes andere geeignete Warnsignal ausgibt.

### Bezugszeichenliste

- 1: elektrisches Leitersystem
- 2: Transformator
- 3: Hochspannungsmast
- 4: Anschlüsse des Transformators
- 5: Zelle in einer Transformatorenanlage
- 6: abgeschaltete Zelle in einer Transformatorenanlage
- 7: Schematische Darstellung eines Defektes oder einer Fehlfunktion in der abgeschalteten Transformatorenzelle
- 8: Sammelschiene
- 10: Verfahrensschritt der Bereitstellung von berechneten Daten
- 11: Verfahrensschritt der Durchführung der zweiten Detektion
- 12: Verfahrensschritt des Erzeugens der Messdaten der zweiten Detektion
- 13: Verfahrensschritt des Erzeugens der aktualisierten berechneten Daten
- 14: Verfahrensschritt zur Ausgabe der aktualisierten berechneten daten
- 20: tragbares Gerät
- 30: Person
- 100: Vorrichtung zur Detektion von elektrischen Spannungen/Strömen
- 101: Detektionsmittel
- 102: Detektionsmittel
- 103: Detektionsmittel
- 104: Auswertemittel
- 105: Ausgabemittel
- 106: Datenspeicher
- 107: Schnittstelle
- 200: Detektion von aktuellen Messgrößen
- 201: Auswertung der Messgrößen
- 202: Erzeugen eines Ausgabesignals
- 203: Bildung eines aktualisierten Satzes von berechneten Daten
- 300: mobile Robotereinheit
- 400: selbstlernendes System
- 401: aktuelle Messgrößen
- 402: berechnete Daten (erste Detektion)
- 403: aktuelle berechnete Daten

## Patentansprüche

1. Verfahren zur automatisierten Erkennung ein oder mehrerer elektrischer Spannungen und/oder elektrischer Ströme,
umfassend:
Bereitstellen (10) von berechneten Daten zu den ein oder mehreren elektrischen Spannungen und/oder den elektrischen Strömen,
wobei die berechneten Daten die räumlichen Positionen mindestens eines Trägers (1, 5, 6) der ein oder mehreren elektrischen Spannungen und/oder der elektrischen Ströme umfassen,
wobei die berechneten Daten aus einem Satz von Messdaten zu einer Mehrzahl erster Detektionen der ein oder mehreren elektrischen Spannungen und/oder der elektrischen Ströme berechnet worden sind,
Durchführen (11) einer zweiten Detektion der ein oder mehreren elektrischen Spannungen und/oder der elektrischen Ströme,
wobei bei der zweiten Detektion Messdaten zu der zweiten Detektion erzeugt (12) werden, und
aus den Messdaten der zweiten Detektion und den berechneten Daten aktualisierte berechnete Daten zu den ein oder mehreren elektrischen Spannungen und/oder den elektrischen Strömen erzeugt (13) werden,
Ausgeben (14) der aktualisierten berechneten Daten, um die räumlichen Positionen und/oder die Eigenschaften des mindestens eines Trägers (1, 5, 6) der ein oder mehreren elektrischen Spannungen und/oder der elektrischen Ströme anzuzeigen,
**dadurch gekennzeichnet, dass** eine mittels eines Armbandes oder eines Stirnbandes am menschlichen Körper tragbare Vorrichtung (100) bereitgestellt wird, welche das vorgenannte Bereitstellen, Durchführen und Ausgeben ausführt.

2. Verfahren nach Anspruch 1, weiter umfassend:
Bereitstellung einer Mehrzahl von Detektionsmitteln zur Detektion einer Mehrzahl von Messgrößen, wobei die Mehrzahl der Messgrößen Eigenschaften der ein oder mehreren elektrischen Spannungen und/oder elektrischer Ströme bestimmen,
wobei mindestens eine Messgröße die Eigenschaften elektrischer und/oder magnetischer und/oder elektromagnetischer Felder quantitativ bestimmt,
wobei aus mindestens einer Messgröße die räumlichen Positionen des mindestens einen Trägers der ein oder mehreren elektrischen Spannungen und/oder der elektrischen Ströme bestimmt werden,
wobei aus mindestens einer Messgröße die räumlichen Positionen der Mehrzahl der Detektionsmittel bestimmt werden,
Bereitstellen mindestens eines Auswertemittels, um aus der Mehrzahl von Messgrößen Messdaten zu erzeugen,
Bereitstellung eines Ausgabemittels, um ein mindestens ein Ausgabesignal zu erzeugen, wobei das mindestens eine Ausgabesignal basierend auf den berechneten Daten und den Messdaten der zweiten Detektion und/oder den aktualisierten berechneten Daten erzeugt wird.

3. Verfahren nach Anspruch 1 oder 2, wobei die berechneten Daten und/oder die aktualisierten berechneten Daten weitere Eigenschaften der ein oder mehreren elektrischen Spannungen und/oder der elektrischen Ströme umfassen können und/oder wobei die Messdaten die räumlichen Positionen der Mehrzahl der Detektionsmittel umfassen, und/oder
wobei mindestens eine Messgröße eine Feldstärke, eine Flussdichte, eine Änderung der Feldstärke, eine Änderung der Flussdichte, eine Kapazität, einen mit dem Vorhandensein der ein oder mehreren elektrischen Spannungen und/oder elektrischen Ströme verbundenen Schall und/oder eine zeitliche und/oder räumliche Änderung der vorgenannten Messgrößen und/oder aus den vorgenannten Messgrößen abgeleitete Messgrößen umfasst, und/oder
wobei die mit den räumlichen Positionen der Mehrzahl der Detektionsmittel verbundene mindestens eine Messgröße das an den räumlichen Positionen der Mehrzahl der Detektionsmittel auftretende Erdmagnetfeld und/oder den an den räumlichen Positionen der Mehrzahl der Detektionsmittel auftretenden Luftdruck und/oder an räumlichen Positionen der Mehrzahl der Detektionsmittel auftretenden Ultraschall bestimmt.

4. Verfahren nach einem der vorhergehenden Ansprüche, wobei die berechneten Daten zusätzlich die räumliche Bewegung und/oder die Beschleunigung der Mehrzahl der Detektionsmittel (101, 102, 103) umfassen.

5. Verfahren nach einem der vorhergehenden Ansprüche, wobei die berechneten Daten und/oder die aktualisierten berechneten Daten mit auf maschinellem Lernen basierenden Verfahren berechnet werden, wobei der Satz von Messdaten zu einer Mehrzahl erster Detektionen als Trainingsdaten für die auf maschinellem Lernen basierenden Verfahren verwendet werden,
und/oder wobei die berechneten Daten und/oder die aktualisierten berechneten Daten in einer Vorrichtung (106) zur Speicherung von Daten gespeichert werden, wobei in einer besonderen Ausführungsform die Vorrichtung (106) zur Speicherung von Daten eine Cloud umfasst.

6. Verfahren nach einen der vorhergehenden Ansprüche, wobei das mindestens eine Ausgabesignal Angaben über die räumlichen Positionen des mindestens einen Trägers der ein oder mehreren elektrischen Spannungen und/oder der elektrischen Ströme umfasst und/oder ein Warnsignal umfasst, welches ausgelöst wird, wenn ein Vergleich der Messdaten der zweiten Detektion mit vorgegebenen Grenzwerten vorgegebene Schwellwerte erreicht.

7. Vorrichtung (100), zur automatisierten Erkennung ein oder mehrerer elektrischer Spannungen und/oder elektrischer Ströme,
umfassend Mittel zum
Bereitstellen (10) von berechneten Daten zu den ein oder mehreren elektrischen Spannungen und/oder den elektrischen Strömen,
wobei die berechneten Daten die räumlichen Positionen mindestens eines Trägers (1, 5, 6) der ein oder mehreren elektrischen Spannungen und/oder der elektrischen Ströme umfassen,
wobei die berechneten Daten aus einem Satz von Messdaten zu einer Mehrzahl erster Detektionen der ein oder mehreren elektrischen Spannungen und/oder der elektrischen Ströme berechnet worden sind,
Durchführen (11) einer zweiten Detektion der ein oder mehreren elektrischen Spannungen und/oder der elektrischen Ströme
wobei bei der zweiten Detektion Messdaten zu der zweiten Detektion erzeugt (12) werden, und
aus den Messdaten der zweiten Detektion und den berechneten Daten aktualisierte berechnete Daten zu den ein oder mehreren elektrischen Spannungen und/oder den elektrischen Strömen erzeugt (13) werden,
Ausgeben (14) der aktualisierten berechneten Daten, um die räumlichen Positionen und/oder die Eigenschaften des mindestens eines Trägers (1, 5, 6) der ein oder mehreren elektrischen Spannungen und/oder der elektrischen Ströme anzuzeigen,
**dadurch gekennzeichnet, dass**
die Vorrichtung (100) mittels eines Armbandes oder eines Stirnbandes am menschlichen Körper tragbar ist

8. Vorrichtung (100) nach Anspruch 7, weiter umfassend:
eine Mehrzahl von Detektionsmitteln (101, 102, 103) zur Detektion einer Mehrzahl von Messgrößen, wobei die Mehrzahl der Messgrößen Eigenschaften der ein oder mehreren elektrischen Spannungen und/oder elektrischer Ströme bestimmen,
wobei mindestens eine Messgröße die Eigenschaften elektrischer und/oder magnetischer und/oder elektromagnetischer Felder quantitativ bestimmt,
wobei aus mindestens einer Messgröße die räumlichen Positionen des mindestens einen Trägers (1, 5, 6) der ein oder mehreren elektrischen Spannungen und/oder der elektrischen Ströme bestimmt werden,
wobei aus mindestens einer Messgröße die räumlichen Positionen der Mehrzahl der Detektionsmittel (101, 102, 103) bestimmt werden,
mindestens ein Auswertemittel (104), um aus der Mehrzahl von Messgrößen Messdaten zu erzeugen,
ein Ausgabemittel, um ein mindestens ein Ausgabesignal zu erzeugen, wobei das mindestens eine Ausgabesignal basierend auf den berechneten Daten und den Messdaten der zweiten Detektion und/oder den aktualisierten berechneten Daten erzeugt wird.

9. Vorrichtung (100) nach Anspruch 7 oder 8, wobei die Vorrichtung (100) so eingerichtet ist, dass die berechneten Daten und/oder die aktualisierten berechneten Daten weitere Eigenschaften der ein oder mehreren elektrischen Spannungen und/oder der elektrischen Ströme umfassen können und/oder wobei die Messdaten die räumlichen Positionen der Mehrzahl der Detektionsmittel umfassen, und/oder
dass mindestens eine Messgröße eine Feldstärke, eine Flussdichte, eine Änderung der Feldstärke, eine Änderung der Flussdichte, eine Kapazität, einen mit dem Vorhandensein der ein oder mehreren elektrischen Spannungen und/oder elektrischen Ströme verbundenen Schall und/oder eine zeitliche und/oder räumliche Änderung der vorgenannten Messgrößen und/oder aus den vorgenannten Messgrößen abgeleitete Messgrößen umfasst, und/oder
dass die mit den räumlichen Positionen der Mehrzahl der Detektionsmittel verbundene mindestens eine Messgröße das an den räumlichen Positionen der Mehrzahl der Detektionsmittel auftretende Erdmagnetfeld und/oder den an den räumlichen Positionen der Mehrzahl der Detektionsmittel auftretenden Luftdruck und/oder an räumlichen Positionen der Mehrzahl der Detektionsmittel auftretenden Ultraschall bestimmt.

10. Vorrichtung (100) nach einem der vorangehenden Ansprüche, wobei die Vorrichtung (100) so eingerichtet ist, dass die berechneten Daten zusätzlich die räumliche Bewegung und/oder die Beschleunigung der Mehrzahl der Detektionsmittel (101, 102, 103) umfassen.

11. Vorrichtung (100) nach einem der vorangehenden Ansprüche, wobei die Vorrichtung (100) so eingerichtet ist, dass die berechneten Daten und/oder die aktualisierten berechneten Daten mit auf maschinellem Lernen basierenden Verfahren berechnet werden, wobei der Satz von Messdaten zu einer Mehrzahl erster Detektionen als Trainingsdaten für die auf maschinellem Lernen basierenden Verfahren verwendet werden,
und/oder die berechneten Daten und/oder die aktualisierten berechneten Daten in einer Vorrichtung (106) zur Speicherung von Daten gespeichert werden, wobei in einer besonderen Ausführungsform die Vorrichtung zur Speicherung von Daten eine Cloud umfasst.

12. Vorrichtung (100) nach einem der vorangehenden Ansprüche, wobei die Ausgabeeinheit (105) so eingerichtet ist, dass das mindestens eine Ausgabesignal Angaben über die räumlichen Positionen des mindestens einen Trägers der ein oder mehreren elektrischen Spannungen und/oder der elektrischen Ströme umfasst und/oder ein Warnsignal umfasst, welches ausgelöst wird, wenn ein Vergleich der Messdaten der zweiten Detektion mit vorgegebenen Grenzwerten vorgegebene Schwellwerte erreicht.

13. Anzeigevorrichtung (20) zum Ausgeben mindestens eines Signals, umfassend die Vorrichtung (100) nach einem der vorangehenden Ansprüche, wobei das mindestens eine Signal das mindestens eine Ausgabesignal nach einem der vorhergehenden Ansprüche umfasst.

## Claims

1. A method for automated detection of one or more electrical voltages and/or electrical currents, comprising:
providing (10) calculated data on the one or more electrical voltages and/or electrical currents,
wherein the calculated data comprise the spatial positions of at least one carrier (1, 5, 6) of the one or more electrical voltages and/or electrical currents,
wherein the calculated data were calculated from a set of measurement data on a plurality of first detections of the one or more electrical voltages and/or electrical currents,
performing (11) a second detection of the one or more electrical voltages and/or electrical currents,
wherein, during the second detection, measurement data on the second detection are generated (12), and
updated calculated data on the one or more electrical voltages and/or electrical currents are generated (13) from the measurement data of the second detection and the calculated data,
outputting (14) the updated calculated data to display the spatial positions and/or properties of the at least one carrier (1, 5, 6) of the one or more electrical voltages and/or electrical currents,
**characterized in that**
a device (100) that is wearable on a human body and that performs the above mentioned providing, performing and outputting is provided by means of a bracelet or a headband.

2. The method according to claim 1, further comprising:
providing a plurality of detection means for detecting a plurality of measured variables, wherein the plurality of the measured variables determines properties of the one or more electrical voltages and/or electrical currents,
wherein at least one measured variable quantitatively determines the properties of electric and/or magnetic and/or electromagnetic fields,
wherein the spatial positions of the at least one carrier of the one or more electrical voltages and/or electrical currents are determined from at least one measured variable, wherein the spatial positions of the plurality of detection means are determined from at least one measured variable,
providing at least one evaluation means to generate measurement data from the plurality of measured variables,
providing an output means to generate at least one output signal, wherein the at least one output signal is generated based on the calculated data and the measurement data of the second detection and/or the updated calculated data.

3. The method according to claim 1 or 2, wherein the calculated data and/or updated calculated data may comprise further properties of the one or more electrical voltages and/or electrical currents, and/or wherein the measurement data comprise the spatial positions of the plurality of detection means, and/or
wherein at least one measured variable comprises a field strength, a flux density, a change in field strength, a change in flux density, a capacity, a sound associated with the presence of the one or more electrical voltages and/or electrical currents, and/or a temporal and/or spatial change of the aforementioned measured variables and/or of measured variables derived from the aforementioned measured variables, and/or
wherein the at least one measured variable associated with the spatial positions of the plurality of detection means determines the earth's magnetic field occurring at the spatial positions of the plurality of detection means and/or the air pressure occurring at the spatial positions of the plurality of detection means and/or ultrasound occurring at spatial positions of the plurality of detection means.

4. The method according to any one of the preceding claims, wherein the calculated data additionally comprise the spatial movement and/or the acceleration of the plurality of detection means (101, 102, 103) .

5. The method according to any one of the preceding claims, wherein the calculated data and/or the updated calculated data are calculated using methods based on machine learning, wherein the set of measurement data on a plurality of first detections is used as training data for the methods based on machine learning,
and/or wherein the calculated data and/or the updated calculated data are stored in a device (106) for storing data, wherein in a particular embodiment the device (106) for storing data comprises a cloud.

6. The method according to any one of the preceding claims, wherein the at least one output signal comprises information about the spatial positions of the at least one carrier of the one or more electrical voltages and/or electrical currents and/or comprises a warning signal that is triggered, when a comparison of the measurement data the second detection with preset limit values reaches preset threshold values.

7. A device (100) for automated detection of one or more electrical voltages and/or electrical currents,
comprising means for
providing (10) calculated data on the one or more electrical voltages and/or electrical currents,
wherein the calculated data comprise the spatial positions of at least one carrier (1, 5, 6) of the one or more electrical voltages and/or electrical currents,
wherein the calculated data were calculated from a set of measurement data on a plurality of first detections of the one or more electrical voltages and/or electrical currents,
performing (11) a second detection of the one or more electrical voltages and/or electrical currents,
wherein, during the second detection, measurement data on the second detection are generated (12), and
updated calculated data on the one or more electrical voltages and/or electrical currents are generated (13) from the measurement data of the second detection and the calculated data,
outputting (14) the updated calculated data to display the spatial positions and/or properties of the at least one carrier (1, 5, 6) of the one or more electrical voltages and/or electrical currents,
**characterized in that**
the device (100) that is wearable on a human body by means of a bracelet or a headband.

8. The device (100) according to claim 7, further comprising:
a plurality of detection means for (101, 102, 103) for detection of a plurality of measured variables, wherein the plurality of the measured variables determines properties of the one or more electrical voltages and/or electrical currents,
wherein at least one measured variable quantitatively determines the properties of electric and/or magnetic and/or electromagnetic fields,
wherein the spatial positions of the at least one carrier (1, 5, 6) of the one or more electrical voltages and/or electrical currents are determined from at least one measured variable,
wherein the spatial positions of the plurality of detection means (101, 102, 103) are determined from at least one measured variable,
at least one evaluation means (104) to generate measurement data from the plurality of measured variables,
an output means to generate at least one output signal, wherein the at least one output signal is generated based on the calculated data and the measurement data of the second detection and/or the updated calculated data.

9. The device (100) according to claim 7 or 8, wherein the device (100) is configured so that the calculated data and/or updated calculated data may comprise further properties of the one or more electrical voltages and/or electrical currents, and/or wherein the measurement data comprise the spatial positions of the plurality of detection means, and/or
that at least one measured variable comprises a field strength, a flux density, a change in field strength, a change in flux density, a capacity, a sound associated with the presence of the one or more electrical voltages and/or electrical currents, and/or a temporal and/or spatial change of the aforementioned measured variables and/or of measured variables derived from the aforementioned measured variables, and/or
that the at least one measured variable associated with the spatial positions of the plurality of detection means determines the earth's magnetic field occurring at the spatial positions of the plurality of detection means and/or the air pressure occurring at the spatial positions of the plurality of detection means and/or ultrasound occurring at spatial positions of the plurality of detection means.

10. The device (100) according to any one of the preceding claims, wherein the device (100) is configured so that the calculated data additionally comprise the spatial movement and/or the acceleration of the plurality of detection means (101, 102, 103).

11. The device (100) according to any one of the preceding claims, wherein the device (100) is configured so that the calculated data and/or the updated calculated data are calculated using methods based on machine learning, wherein the set of measurement data on a plurality of first detections is used as training data for the methods based on machine learning,
and/or that the calculated data and/or the updated calculated data are stored in a device (106) for storing data, wherein in a particular embodiment the device for storing data comprises a cloud.

12. The device (100) according to any one of the preceding claims, wherein the output unit (105) is configured so that the at least one output signal comprises information about the spatial positions of the at least one carrier of the one or more electrical voltages and/or electrical currents and/or comprises a warning signal that is triggered, when a comparison of the measurement data the second detection with preset limit values reaches preset threshold values.

13. A display device (20) for outputting of at least one signal, comprising the device (100) according to any one of the preceding claims, wherein the at least one signal comprises the at least one output signal according to any one of the preceding claims.

## Revendications

1. Procédé pour l'identification automatique d'une ou plusieurs tensions électriques et/ou de courants électriques,
comprenant :
la fourniture (10) de données calculées concernant les une ou plusieurs tensions électriques et/ou aux courants électriques,
dans lequel les données calculées comprennent les positions spatiales d'au moins un porteur (1, 5, 6) des une ou plusieurs tensions électriques et/ou des courants électriques,
dans lequel les données calculées ont été calculées à partir d'un ensemble de données de mesure concernant une pluralité de premières détections des une ou plusieurs tensions électriques et/ou des courants électriques,
la mise en œuvre (11) d'une deuxième détection des une ou plusieurs tensions électriques et/ou des courants électriques,
dans lequel lors de la deuxième détection des données de mesure concernant la deuxième détection sont produites (12), et
à partir des données de mesure de la deuxième détection et des données calculées des données calculées actualisées concernant les une ou plusieurs tensions électriques et/ou les courants électriques sont produites (13),
la sortie (14) des données calculées actualisées, afin d'afficher les positions spatiales et/ou les propriétés du au moins un porteur (1, 5, 6) des une ou plusieurs tensions électriques et/ou des courants électriques,
**caractérisé en ce que**
un dispositif (100) pouvant être porté sur le corps humain au moyen d'un bracelet ou d'un bandeau est fourni, lequel réalise la fourniture, la mise en œuvre et la sortie susmentionnées.

2. Procédé selon la revendication 1, comprenant en outre :
la fourniture d'une pluralité de moyens de détection pour la détection d'une pluralité de grandeurs de mesure, dans lequel la pluralité des grandeurs de mesure déterminent les propriétés des une ou plusieurs tensions électriques et/ou courants électriques,
dans lequel au moins une grandeur de mesure détermine de manière quantitative les propriétés de champs électriques et/ou magnétiques et/ou électromagnétiques,
dans lequel les positions spatiales du au moins un porteur des une ou plusieurs tensions électriques et/ou des courants électriques sont déterminées à partir d'au moins une grandeur de mesure,
dans lequel les positions spatiales de la pluralité des moyens de détection sont déterminées à partir d'au moins une grandeur de mesure,
la fourniture d'au moins un moyen d'évaluation, afin de produire des données de mesure à partir de la pluralité de grandeurs de mesure,
la fourniture d'un moyen de sortie, afin de produire un au moins un signal de sortie, dans lequel le au moins un signal de sortie est produit sur la base des données calculées et des données de mesure de la deuxième détection et/ou des données calculées actualisées.

3. Procédé selon la revendication 1 ou 2, dans lequel les données calculées et/ou les données calculées actualisées peuvent comprendre d'autres propriétés des une ou plusieurs tensions électriques et/ou des courants électriques et/ou dans lequel les données de mesure comprennent les positions spatiales de la pluralité des moyens de détection, et/ou
dans lequel au moins une grandeur de mesure comprend une intensité de champ, une densité de flux, une variation de l'intensité de champ, une variation de la densité de flux, une capacité, un bruit lié à la présence des une ou plusieurs tensions électriques et/ou courants électriques et/ou une variation temporelle et/ou spatiale des grandeurs de mesure susmentionnées et/ou des grandeurs de mesure déduites des grandeurs de mesure susmentionnées, et/ou
dans lequel la au moins une grandeur de mesure reliée aux positions spatiales de la pluralité des moyens de détection détermine le champ magnétique terrestre apparaissant aux positions spatiales de la pluralité des moyens de détection et/ou la pression atmosphérique apparaissant aux positions spatiales de la pluralité des moyens de détection et/ou un ultrason apparaissant aux positions spatiales de la pluralité des moyens de détection.

4. Procédé selon l'une quelconque des revendications précédentes, dans lequel les données calculées comprennent en plus le mouvement spatial et/ou l'accélération de la pluralité des moyens de détection (101, 102, 103).

5. Procédé selon l'une quelconque des revendications précédentes, dans lequel les données calculées et/ou les données calculées actualisées sont calculées avec un procédé basé sur l'apprentissage machine, dans lequel l'ensemble de données de mesure concernant une pluralité de premières détections sont utilisées en tant que données d'apprentissage pour les procédés basés sur l'apprentissage machine,
et/ou dans lequel les données calculées et/ou les données calculées actualisées sont stockées dans un dispositif (106) pour le stockage de données, dans lequel dans un mode de réalisation particulier le dispositif (106) pour le stockage de données comprend un nuage.

6. Procédé selon l'une quelconque des revendications précédentes, dans lequel le au moins un signal de sortie comprend des indications sur les positions spatiales du au moins un porteur des une ou plusieurs tensions électriques et/ou des courants électriques et/ou comprend un signal d'avertissement, lequel est déclenché lorsqu'une comparaison des données de mesure de la deuxième détection à des valeurs limites prédéfinies atteint des valeurs de seuil prédéfinies.

7. Dispositif (100), pour l'identification automatique d'une ou plusieurs tensions électriques et/ou de courants électriques,
comprenant des moyens pour
la fourniture (10) de données calculées concernant les une ou plusieurs tensions électriques et/ou les courants électriques,
dans lequel les données calculées comprennent les positions spatiales d'au moins un porteur (1, 5, 6) des une ou plusieurs tensions électriques et/ou des courants électriques,
dans lequel les données calculées ont été calculées à partir d'un ensemble de données de mesure concernant une pluralité de premières détections des une ou plusieurs tensions électriques et/ou des courants électriques,
la mise en œuvre (11) d'une deuxième détection des une ou plusieurs tensions électriques et/ou des courants électriques
dans lequel lors de la deuxième détection des données de mesure concernant la deuxième détection sont produites (12), et
à partir des données de mesure de la deuxième détection et des données calculées des données calculées actualisées concernant les une ou plusieurs tensions électriques et/ou les courants électriques sont produites (13),
la sortie (14) des données calculées actualisées, afin d'afficher les positions spatiales et/ou les propriétés du au moins un porteur (1, 5, 6) des une ou plusieurs tensions électriques et/ou des courants électriques,
**caractérisé en ce que**
le dispositif (100) peut être porté sur le corps humain au moyen d'un bracelet ou d'un bandeau.

8. Dispositif (100) selon la revendication 7, comprenant en outre :
une pluralité de moyens de détection (101, 102, 103) pour la détection d'une pluralité de grandeurs de mesure, dans lequel la pluralité des grandeurs de mesure déterminent les propriétés des une ou plusieurs tensions électriques et/ou courants électriques,
dans lequel au moins une grandeur de mesure détermine de manière quantitative les propriétés de champs électriques et/ou magnétiques et/ou électromagnétiques,
dans lequel les positions spatiales du au moins un porteur (1, 5, 6) des une ou plusieurs tensions électriques et/ou des courants électriques sont déterminées à partir d'au moins une grandeur de mesure,
dans lequel les positions spatiales de la pluralité des moyens de détection (101, 102, 103) sont déterminées à partir d'au moins une grandeur de mesure,
au moins un moyen d'évaluation (104), afin de produire des données de mesure à partir de la pluralité de grandeurs de mesure,
un moyen de sortie, afin de produire un au moins un signal de sortie, dans lequel le au moins un signal de sortie est produit sur la base des données calculées et des données de mesure de la deuxième détection et/ou des données calculées actualisées.

9. Dispositif (100) selon la revendication 7 ou 8, dans lequel le dispositif (100) est conçu de sorte que les données calculées et/ou les données calculées actualisées peuvent comprendre d'autres propriétés des une ou plusieurs tensions électriques et/ou des courants électriques et/ou dans lequel les données de mesure comprennent les positions spatiales de la pluralité des moyens de détection, et/ou
qu'au moins une grandeur de mesure comprend une intensité de champ, une densité de flux, une variation de l'intensité de champ, une variation de la densité de flux, une capacité, un bruit lié à la présence des une ou plusieurs tensions électriques et/ou courants électriques et/ou une variation temporelle et/ou spatiale des grandeurs de mesure susmentionnées et/ou des grandeurs de mesure déduites des grandeurs de mesure susmentionnées, et/ou
que la au moins une grandeur de mesure reliée aux positions spatiales de la pluralité des moyens de détection détermine le champ magnétique terrestre apparaissant aux positions spatiales de la pluralité des moyens de détection et/ou la pression atmosphérique apparaissant aux positions spatiales de la pluralité des moyens de détection et/ou un ultrason apparaissant aux positions spatiales de la pluralité des moyens de détection.

10. Dispositif (100) selon l'une quelconque des revendications précédentes, dans lequel le dispositif (100) est conçu de sorte que les données calculées comprennent en plus le mouvement spatial et/ou l'accélération de la pluralité des moyens de détection (101, 102, 103).

11. Dispositif (100) selon l'une quelconque des revendications précédentes, dans lequel le dispositif (100) est conçu de sorte que les données calculées et/ou les données calculées actualisées sont calculées avec un procédé basé sur l'apprentissage machine, dans lequel l'ensemble de données de mesure concernant une pluralité de premières détections sont utilisées en tant que données d'apprentissage pour les procédés basés sur l'apprentissage machine,
et/ou les données calculées et/ou les données calculées actualisées sont mises en mémoire dans un dispositif (106) pour le stockage de données, dans lequel dans un mode de réalisation particulier le dispositif pour le stockage de données comprend un nuage.

12. Dispositif (100) selon l'une quelconque des revendications précédentes, dans lequel l'unité de sortie (105) est conçue de sorte que le au moins un signal de sortie comprend des indications sur les positions spatiales du au moins un porteur des une ou plusieurs tensions électriques et/ou des courants électriques et/ou comprend un signal d'avertissement, lequel est déclenché lorsqu'une comparaison des données de mesure de la deuxième détection à des valeurs limites prédéfinies atteint des valeurs de seuil prédéfinies.

13. Dispositif d'affichage (20) pour la sortie d'au moins un signal, comprenant le dispositif (100) selon l'une quelconque des revendications précédentes, dans lequel le au moins un signal comprend le au moins un signal de sortie selon l'une quelconque des revendications précédentes.
